# EUROPÄISCHE PATENTSCHRIFT

(11) **EP 3 316 477 B1**
(45) Veröffentlichungstag und Bekanntmachung des Hinweises auf die Patenterteilung: **25.08.2021**
(21) Anmeldenummer: 16195987.9
(22) Anmeldetag: 27.10.2016
(51) Int. Cl.: H02P 27/06, G01R 31/42

(54) **VERFAHREN ZUR NACHBILDUNG EINES DREIPHASIGEN ELEKTROMOTORS MIT EINEM LASTEMULATOR UND ENTSPRECHENDER LASTEMULATOR**
METHOD FOR EMULATING A THREE-PHASE ELECTRIC MOTOR WITH A LOAD EMULATOR AND CORRESPONDING LOAD EMULATOR
PROCÉDÉ DE SIMULATION D'UN MOTEUR ÉLECTRIQUE TRIPHASÉ À L'AIDE D'UN ÉMULATEUR DE CHARGE ET ÉMULATEUR DE CHARGE CORRESPONDANT

(43) Veröffentlichungstag der Anmeldung: 02.05.2018
(73) Patentinhaber: dSPACE digital signal processing and control engineering GmbH, 33102 Paderborn (DE)
(72) Erfinder: Holthaus, Nils, 33189 Schlangen (DE)

(56) Entgegenhaltungen:
- EP-A1- 2 940 857
- DE-A1-102012 111 051
- JP-A- 2008 118 797
- OETTMEIER M ET AL: "Power-electronic-based machine emulator for high-power high-frequency drive converter test", VEHICLE POWER AND PROPULSION CONFERENCE (VPPC), 2010 IEEE, IEEE, 1. September 2010 (2010-09-01), Seiten 1-6, XP031929124, DOI: 10.1109/VPPC.2010.5728988 ISBN: 978-1-4244-8220-7

## Beschreibung

Die Erfindung betrifft ein Verfahren zur Nachbildung eines dreiphasigen Elektromotors mit einem Lastemulator, wobei der Lastemulator dreiphasig über seine Lastanschlüsse an die Speiseanschlüsse einer Motorsteuerung angeschlossen ist und der Lastemulator eine Emulatorleistungselektronik und eine Emulatorsteuerung zur Steuerung der Emulatorleistungselektronik aufweist, wobei die Emulatorsteuerung die von der Motorsteuerung angesteuerten Speiseanschlüsse und nicht angesteuerten Speiseanschlüsse ermittelt, und die Emulatorleistungselektronik durch die Emulatorsteuerung so angesteuert wird, dass in den durch die Motorsteuerung angesteuerten Speiseanschlüssen von der Emulatorsteuerung auf Grundlage eines Motormodells berechnete Phasenströme *iₑₘᵤₗₐₜₑ* fließen und auf den von der Motorsteuerung nicht angesteuerten Speiseanschluss eine von der Emulatorsteuerung auf Grundlage eines Motormodells berechnete Phasenspannung *vₑₘᵤₗₐₜₑ* aufgegeben wird. Die Erfindung betrifft ferner auch die Emulatorsteuerung eines Lastemulators, die so ausgestaltet ist, dass sie das zuvor beschriebene Verfahren zur Nachbildung eines dreiphasigen Elektromotors in Zusammenhang mit einer Emulatorleistungselektronik ausführen kann.

Verfahren zur Nachbildung elektrischer Lasten mit Hilfe von Lastemulatoren dienen dazu, Motorsteuerungen unter Laborbedingungen zu testen, ohne dass an den Steuerungen ein "echter" elektrischer Antrieb - hier in Form eines dreiphasigen Elektromotors - anzuschließen wäre. Die elektrische Last, also der dreiphasige Elektromotor, wird vielmehr von dem Lastemulator nachgebildet. Die Motorsteuerung besteht oft aus einem Steuergerät mit einer Leistungsendstufe in Form eines Umrichters. Das Steuergerät erzeugt Stromrichtersteuerdaten, die zur geeigneten Ansteuerung der Leistungsschalter des Umrichters dienen, die üblicherweise mittels Halbleiterschaltelementen (IGBT, IGCT usw.) realisiert sind. Im vorliegend betrachteten Anwendungsfall arbeitet der Umrichter der Motorsteuerung als Wechselrichter, er weist also als Energiequelle eine Gleichspannungsquelle auf und treibt eine Last mit Wechselspannung. Der Umrichter der Motorsteuerung umfasst üblicherweise eine mit den genannten Leistungsschaltern realisierte Halbbrückenschaltung, wobei die Leistungsschalter mit antiparallel geschalteten Freilaufdioden versehen sind, über die sich bei geöffnetem Leistungsschalter durch die Induktivitäten des Motors getriebene Ströme abbauen können.

Der Lastemulator wird oft in Form eines Hardware-in-the-Loop-Simulators realisiert, also durch einen Simulationsrechner, der mathematische Modelle der zu simulierenden Umgebung - hier die Last in Form dreiphasigen Elektromotors - mit numerischen Verfahren berechnet und seinerseits über eine leistungselektronische Endstufe - die Emulatorleistungselektronik - verfügt, die über die Lastanschlüsse des Lastemulators mit den korrespondierenden Speiseanschlüssen der Motorsteuerung verbunden werden kann. Das auf dem Lastemulator implementierte Verfahren zur Nachbildung eines dreiphasigen Elektromotors sorgt im Ergebnis dafür, dass die Motorsteuerung über ihre Speiseanschlüsse elektrisch so belastet wird, als wäre sie mit dem echten Antrieb verbunden.

Ein vorbeschriebenes Verfahren zur Nachbildung eines dreiphasigen Elektromotors ist beispielsweise aus der EP 2940857 A1 bekannt. Hier handelt es sich bei dem dreiphasigen Elektromotor ausschließlich um einen bürstenlosen Gleichstrommotor. Auf die Offenbarung dieser Anmeldung wird aufgrund ihrer inhaltlichen Nähe Bezug genommen. Bürstenlose Gleichstrommotoren sind aufgrund der bürstenlosen Konstruktion verschleiß- und wartungsarm. Darüber hinaus ist aus der JP200811879A eine Methode und ein System zur Motorsimulation zum Testen eines Umrichters mittels einer simulierten Last bekannt.

Bei blockkommutiert angesteuerten bürstenlosen Gleichstrommotoren werden von der Motorsteuerung immer zwei der drei Motorphasen angesteuert - zwei der drei Speiseanschlüsse der Motorsteuerungen sind dann angesteuert - und die dritte Phase der dreiphasigen Drehstromwicklung wird durch die Motorsteuerungen nicht angesteuert, der entsprechende Speiseanschluss der Motorsteuerung ist dann ebenfalls nicht angesteuert. Durch periodisches Umschalten der Drehstromwicklungen durch die Motorsteuerung wird ein magnetisches Drehfeld erzeugt. In der von der Motorsteuerung nicht angesteuerten Phase des bürstenlosen Gleichstrommotors sinkt der Phasenstrom ab und kommt bald vollständig zum Erliegen. Die nicht angesteuerte Phase des bürstenlosen Gleichstrommotors wird oft auch als unbestromte Phase bezeichnet, wobei - wie zuvor erläutert - die Zustände des nicht-Angesteuertwerdens und des Unbestromtseins zeitlich auseinanderfallen können. Wenn eine Phase des bürstenlosen Gleichstrommotors von der Motorsteuerung nicht mehr angesteuert wird, ist die Folge, dass der Phasenstrom in der nicht mehr angesteuerten Phase letztlich, aber nicht zwingend sofort nach der Kommutierung, zum Erliegen kommt und die Phase also tatsächlich unbestromt ist.

In der nicht angesteuerten Phase des bürstenlosen Gleichstrommotors wird jedoch eine Gegenspannung induziert, deren Erfassung für die Ansteuerung des bürstenlosen Gleichstrommotors von erheblicher Bedeutung ist, da aus ihr der Lagewinkel des Rotors bestimmbar ist und die Motorsteuerung so auch ohne einen separaten Winkelgeber den Zeitpunkt der nächsten Kommutierung, also den Zeitpunkt der Umschaltung von nicht angesteuerten Speiseanschlüssen zu angesteuerten Speiseanschlüssen und umgekehrt ermitteln kann. Deshalb ist auch bei der Emulation von blockkommutierten bürstenlosen Gleichstrommotoren die Nachbildung der in der nicht angesteuerten Phase induzierten Gegenspannung essenziell, damit die Motorsteuerung auch ohne Winkelgeber den Zeitpunkt der nächsten Kommutierung bestimmen kann. Aber auch bei mit einem Winkelgeber ausgestatteten bürstenlosen Gleichstrommotoren ist die Berechnung der Gegenspannung im Rahmen der Emulation wichtig, da nur so die physikalischen Verhältnisse des emulierten Motors und damit die Anschlusswerte richtig berechnet und nachgebildet werden können.

Die Emulatorleistungselektronik umfasst zur Beaufschlagung der Speiseanschlüsse der Motorsteuerung mit entsprechenden elektrischen Anschlusswerten Spannungsquellen und Stromquellen, die meist über Entkopplungsinduktivitäten mit den Lastanschlüssen der Emulatorleistungselektronik verbindbar sind. So kann durch entsprechendes Verbinden der Spannungsquellen und Stromquellen mit den Lastanschlüssen der Emulatorleistungselektronik darauf reagiert werden, ob ein Lastanschluss im Falle des nicht angesteuerten Zustandes durch die Motorsteuerung nur mit einer induzierten Gegenspannung beaufschlagt wird oder ein Lastanschluss im Falle des angesteuerten Zustandes durch die Motorsteuerung stromführend ist. Durch die zwischen den Lastanschlüssen und den Spannungs- bzw. Stromquellen vorgesehenen Entkopplungsinduktivitäten wird eine unverzögerte Wirkungsentfaltung der durch die geschalteten Spannungs- bzw. Stromquellen vorgegebenen elektrischen Anschlusswerte auf die Lastanschlüsse verhindert.

Die EP 2940857 A1 beschreibt ein Verfahren, das eine qualitativ hochwertige Nachbildung eines dreiphasigen bürstenlosen Gleichstrommotors mit einem Lastemulator ermöglicht, indem Zeitpunkt der Kommutierung zuverlässig auch unter wechselnden Betriebsbedingungen erkannt wird. Dies betrifft den Normalbetrieb des dreiphasigen Gleichstrommotors.

Mit dem aus dem Stand der Technik bekannten Verfahren ist es also möglich, das motorische Verfahren von dreiphasigen Gleichstrommotoren nachzubilden und den Wechsel der Ansteuerung der verschiedenen Phasen des Gleichstrommotors durch die Motorsteuerung zu erkennen und darauf entsprechend zu reagieren.

Es besteht ein großes Interesse daran, das aus dem Stand der Technik bekannte Verfahren so zu erweitern, dass praktisch beliebige dreiphasige Elektromotoren mit einem Lastemulator nachgebildet werden können, also beispielsweise permanent erregte Synchronmaschinen oder auch Asynchron-Motoren unter sinus-kommutierter oder vergleichbarer Ansteuerung. Der wesentliche Unterschied einer sinus-kommutierten Ansteuerung zu einer block-kommutierten Ansteuerung besteht darin, dass bei einer sinuskommutierten Ansteuerung sämtliche Motorphasen unterbrechungslos angesteuert werden, also keine der Motorphasen während des Betriebs unangesteuert und damit unbestromt ist. Es werden permanent definierte Spannungen von der Leistungselektronik der Motorsteuerung an die Speiseanschlüsse der Motorsteuerung ausgegeben.

Mit dem aus dem Stand der Technik bekannten Verfahren zur Nachbildung eines dreiphasigen Elektromotors mit einem Lastemulator ist es darüber hinaus nicht - oder nur mit großen Einschränkungen - möglich, auf Sondersituationen beim Betrieb eines elektrischen Motors angemessen zu reagieren. Derartige Sondersituationen betreffen beispielsweise die Handhabung von Initialisierungsroutinen der Motorsteuerung, deren Aufgabe unter anderem darin besteht, den Anschluss des Elektromotors an das Steuergerät und grundlegende Eigenschaften des Elektromotors (z. B. vorhandener Kurzschluss, Unterbrechung) zu prüfen, indem die Endstufe der Motorsteuerung zum Beispiel eine beliebige Spannung auf eine Motorphase aufgibt und auf den anderen Phasen zurückmisst. Andere derartige Routinen dienen beispielsweise der Motordiagnose.

Aufgabe der vorliegenden Erfindung ist es also, das eingangs beschriebene Verfahren zur Nachbildung eines dreiphasigen Elektromotors mit einem Lastemulator so weiterzuentwickeln, dass es nicht auf den Betrieb von bürstenlosen dreiphasigen Gleichstrommotoren beschränkt ist und auch Sonderbetriebssituationen eines dreiphasigen Elektromotors berücksichtigt, die jenseits des motorischen oder generatorischen Normalbetriebs liegen.

Die zuvor hergeleitete und aufgezeigte Aufgabe ist bei dem eingangs dargestellten Verfahren zur Nachbildung eines dreiphasigen Elektromotors dadurch gelöst, dass der Lastemulator ein Schaltmittel umfasst, mit dem die Emulatorleistungselektronik hochohmig von den Speiseanschlüssen abgeschaltet werden kann und mit dem die Emulatorleistungselektronik niederohmig an die Speiseanschlüsse zugeschaltet werden kann, und wobei die Speiseanschlüssen über ein hochohmiges Widerstandsnetzwerk miteinander verbunden sind. Ferner wird zur Simulation von ausgewählten Betriebszuständen des Elektromotors die Emulatorleistungselektronik mit dem Schaltmittel hochohmig von den Speiseanschlüssen abgetrennt oder wird die bereits mit hochohmig von den Speiseanschlüssen abgetrennte Emulatorleistungselektronik mit dem Schaltungsmittel niederohmig an die Speiseanschlüsse zugeschaltet.

Zur Durchführung des erfindungsgemäßen Verfahrens wird der Lastemulator schaltungstechnisch um ein Schaltmittel und um ein hochohmiges Widerstandsnetzwerk ergänzt. Das Schaltmittel gestattet es, die Emulatorleistungselektronik hochohmig von den Speiseanschlüssen abzuschalten und natürlich auch umgekehrt, die Emulatorleistungselektronik niederohmig an die Speiseanschlüsse wieder zuzuschalten. Durch diese Maßnahme ist es zunächst grundsätzlich möglich, die Emulatorleistungselektronik wirksam elektrisch von der Motorsteuerung zu trennen. Diese "Trennung" kann über verschiedene schaltungstechnische Maßnahmen realisiert werden. Es ist nicht erforderlich, dass eine vollständige galvanische Entkopplung vorliegt, es reicht auch, wenn ein sehr hochohmiges elektrisches Abtrennen der Emulatorleistungselektronik von den Speiseanschlüssen möglich ist, beispielsweise durch Halbleiterschalter, die keine perfekte galvanische Trennung darstellen. Durch das vorgesehene Schaltmittel ist es also möglich, eine Wechselwirkung zwischen der Motorsteuerung und der Emulatorleistungselektronik zu unterbinden, was in manchen Situationen vorteilhaft ist, wie nachfolgend noch aufgezeigt wird.

Zusätzlich sind die Speiseanschlüsse über ein hochohmiges Widerstandsnetzwerk miteinander verbunden. Diese Verbindung der Speiseanschlüsse über das hochohmige Widerstandsnetzwerk wird dabei nicht durch das Schaltmittel beeinflusst, das hochohmige Widerstandsnetzwerk ist also auch dann mit den Speiseanschlüssen verbunden, wenn mit dem Schaltmittel die Emulatorleistungselektronik hochohmig von den Speiseanschlüssen abgeschaltet ist. Die hochohmige Verbindung der Speiseanschlüsse über das Widerstandsnetzwerk ist genau so gewählt, dass das Widerstandsnetzwerk im Normalbetrieb des Lastemulators, also wenn es eine funktionierende niederohmige Verbindung zwischen der Emulatorleistungselektronik und den Speiseanschlüssen gibt, die Motorsteuerung nur unwesentlich belastet. Der Sinn des Widerstandsnetzwerkes liegt darin, dass die Speiseanschlüsse der Motorsteuerung, die ja mit den Lastanschlüssen des Lastemulators verbunden sind, auch dann be schaltet sind, wenn die Emulatorleistungselektronik hochohmig mit dem Schaltmittel von den Lastanschlüssen bzw. von den Speiseanschlüssen abgeschaltet worden ist. Die Speiseanschlüsse der Motorsteuerung sind dann nicht elektrisch offen, sondern über das hochohmige Widerstandsnetzwerk miteinander verbunden.

Dadurch ist schaltungstechnisch die Voraussetzung dafür geschaffen, dass auf bestimmte Betriebsarten der Motorsteuerung grundsätzlich reagiert werden kann, selbst dann, wenn die Emulatorleistungselektronik hochohmig von der Motorsteuerung abgetrennt ist. Dies ist beispielsweise dann gewünscht, wenn die Motorsteuerung in einer Initialisierungsphase eine Spannung auf die Speiseanschlüsse oder ein Spannungsmuster auf verschiedene Speiseanschlüsse gibt und versucht, über die anderen Speiseanschlüsse eine Spannung rückzumessen, um so Informationen über den scheinbar angeschlossenen Motor zu erhalten. In diesem Fall ist eine derartige Rückmeldung über das hochohmige Widerstandsnetzwerk ohne Weiteres möglich. Das hochohmige Widerstandsnetzwerk repräsentiert für die Motorsteuerung also den angeschlossenen Motor, auch wenn die Emulatorleistungselektronik hochohmig von den Speiseanschlüssen abgeschaltet worden ist.

Zur Handhabung des ausgewählten Betriebszustandes der Initialisierung von Motorsteuerung und des Elektromotors wird also mit dem Schaltmittel die Emulatorleistungselektronik hochohmig von den Speiseanschlüssen abgetrennt. Umgekehrt kann es vorteilhaft sein, bei dem ausgewählten Betriebszustand des Anstartens des Elektromotors zunächst mit dem Schaltmittel die Emulatorleistungselektronik von den Speiseanschlüssen abzutrennen und die von der Motorsteuerung ausgegebenen Signalmuster an den Speiseanschlüssen zu beobachten, um dann, nach einer geeigneten Einstellung und Synchronisierung des Lastemulators, die Emulatorleistungselektronik wieder niederohmig an die Speiseanschlüsse zuzuschalten, sodass hier also von dem hochohmig abgetrennten Zustand in den niederohmig zugeschalteten Zustand gewechselt wird.

Vorzugsweise ist das Verfahren zur Nachbildung eines dreiphasigen Elektromotors mit einem Lastemulator so ausgestaltet, dass als hochohmiges Widerstandsnetzwerk eine Sternschaltung von drei im Wesentlichen ohmschen Widerständen gewählt wird, wobei jedes der freien Enden der Sternschaltung mit jeweils einem anderen Speiseanschluss der Motorsteuerung verbunden ist. Durch die symmetrische Sternschaltung werden die in der Regel ebenfalls symmetrisch ausgestalteten Phasen des nachzubildenden dreiphasigen Elektromotors nachgebildet. Der Sternpunkt ist potenzialmäßig frei, es stellt sich also hier das Potenzial ein, das sich durch die entsprechende spannungsmäßige Ansteuerung der freien Enden der Sternschaltung durch die Speiseanschlüsse der Motorsteuerung ergibt, jedenfalls ist das der bestimmende Einfluss, wenn die Emulatorleistungselektronik hochohmig von den Speiseanschlüssen abgetrennt ist.

Bei einer Weiterbildung des Verfahrens ist vorgesehen, dass als Ausgangszustand die Motorsteuerung keinen Speiseanschluss ansteuert und die Emulatorleistungselektronik mit dem Schaltmittel hochohmig von den Lastanschlüssen abgetrennt ist, dass ein motorischer Motoranstart durch eine beginnende Ansteuerung der Speiseanschlüsse durch die Motorsteuerung erkannt wird, wenn zumindest eine der zwischen den Speiseanschlüssen *i, j* der Motorsteuerung durch Messung ermittelten Ausgangsdifferenzspannungen *v_{inv,diff} (i,j)* größer ist als ein vorbestimmter Spannungsschwellwert *TH_{impedance}.*

Dies ist ein Beispiel für einen Zustandswechsel aus dem hochohmigen Zustand heraus, indem die von den Speiseanschlüssen rückgemessenen Spannungen - und damit auch die ermittelbaren oder direkt messbaren Ausgangsdifferenzspannungen - berücksichtigt werden. Der Motor wird hier aus dem Stillstand heraus motorisch angetrieben, sodass über die Leistungsendstufe der Motorsteuerung Spannungen zur Bestromung des dreiphasigen Elektromotors über die Speiseanschlüsse ausgegeben werden. Diese Ausgangsspannungen *vᵢₙᵥ* werden dann entweder auf die Zwischenkreisspannung *v_{DC_Link}* oder auf das Ground-Potenzial gezogen. Um nicht bei beliebig kleinen Ausgangsdifferenzspannungen *v_{inv,diff}* sofort aus dem hochohmigen Zustand herauszuwechseln, wird ein bestimmter Spannungsschwellwert *THimpedance* vorgegeben.

Umgekehrt kann auch der generatorische Fall erkannt werden, wenn also der nachgebildete dreiphasige Elektromotor über eine Last angetrieben wird. In diesem Fall ist vorgesehen, dass als Ausgangszustand die Motorsteuerung keinen Speiseanschluss ansteuert und die Emulatorleistungselektronik mit dem Schaltmittel hochohmig von den Lastanschlüssen abgetrennt ist, und dass ein generatorischer Motoranstart erkannt wird, wenn die Motordrehzahl des Motormodells ausgewertet wird und die Motordrehzahl ungleich Null ist.

In diesem Fall sind sämtliche Halbbrücken-Schalter der Motorsteuerung geöffnet. Wenn der dreiphasige Elektromotor mit einer bestimmten Drehzahl angetrieben wird, wird in den Statorwicklungen eine elektrische Gegenspannung induziert. Solange alle zwischen zwei Motorphasen messbaren induzierten Gegenspannungen kleiner sind als die an den Speiseanschlüssen der Motorsteuerung anliegenden Zwischenkreisspannungen, fließt kein Strom durch die Statorwicklungen, sodass die induzierten Gegenspannungen zwischen zwei beliebigen Phasen von der Motorsteuerung messbar sind. Dieser Zustand liegt auch dann vor, wenn der nicht-angesteuerte Motor austrudelt, der Motor also nicht von extern mit einem Drehmoment beaufschlagt wird, sondern aufgrund des Trägheitsmoments der rotierenden Teile eine zuvor vorhandene Drehzahl langsam abbaut. Als Bedingung für den Übergang vom hochohmig abgetrennten Zustand in den angesteuerten Zustand, in dem die Emulatorleistungselektronik wieder niederohmig mit den Lastanschlüssen verbunden ist, wird die simulierte Drehzahl ausgewertet; eine tatsächliche Drehzahl ist natürlich nicht vorhanden, da der dreiphasige Elektromotor in der Emulatorsteuerung nur nachgebildet ist. Sobald sich der nachgebildete Elektromotor dreht, wird mit allen Phasen in den angesteuerten Zustand gewechselt, beispielsweise indem auf die Lastanschlüsse eine Spannung aufgegeben wird (Spannungsmodus).

Bei beiden vorgenannten Weiterbildungen des Verfahrens, bei denen einmal im motorischen und einmal im generatorischen Fall aus dem hochohmig abgetrennten Zustand gewechselt wird, ist bevorzugt vorgesehen, dass bei erkanntem motorischen oder generatorischen Motoranstart die Emulatorleistungselektronik mit dem Schaltungsmittel niederohmig an die Speiseanschlüsse zugeschaltet wird und die Emulatorsteuerung die Lastanschlüsse der Emulatorleistungselektronik so ansteuert, dass die Speiseanschlüsse mit einer Spannung beaufschlagt werden. Eingangs ist erläutert worden, dass die Emulatorleistungselektronik zur Beaufschlagung der Speiseanschlüsse der Motorsteuerung mit entsprechenden elektrischen Anschlusswerten Spannungsquellen und Stromquellen aufweist. In diesem Fall wird also von den Spannungsquellen Gebrauch gemacht, die eine bestimmte Spannung auf die Speiseanschlüssen aufgeben - im Regelfall wird das über die Lastanschlüsse der Emulatorleistungselektronik geschehen -, nachdem wieder eine niederohmige Verbindung hergestellt ist zwischen der Emulatorleistungselektronik und den Speiseanschlüssen.

Bei einer Weiterbildung des vorgenannten Verfahrens ist zusätzlich vorgesehen, dass die Emulatorsteuerung die Lastanschlüsse der Emulatorleistungselektronik so ansteuert, dass die Speiseanschlüsse mit einer Testspannung beaufschlagt werden, die von der Motorsteuerung nicht auf die Speiseanschlüsse gegeben werden kann, insbesondere wobei die Testspannung der halben Zwischenkreisspannung *v_{DC_Link}* der Motorsteuerung entspricht. Diese Maßnahme ermöglicht es, herauszufinden, welche der Speiseanschlüsse von der Motorsteuerung angesteuert werden, ob alle Speiseanschlüsse permanent angesteuert werden - wie im Fall einer Sinus-Kommutierung - oder nur zwei der drei Speiseanschlüsse wechselnd angesteuert werden - wie im Fall der Block-Kommutierung.

Befinden sich alle Phasen im Spannungsmodus, so wird bei einer bevorzugten Ausgestaltung des Verfahrens vorgesehen, dass als Spannungssollwert jeweils die Testspannung (*v_{DC_Link}*/2) zuzüglich der simulierten induzierten Gegenspannungen in der entsprechenden Motorphase herangezogen wird. Dann ist die Testspannung lediglich ein Offset für die emulierten induzierten Phasenspannungen. Bei stehendem Motor als Initialzustand sind die induzierten Gegenspannungen gleich Null. Wird der Motor aber generatorisch bei offenen Brückenschaltern betrieben oder trudelt der Motor bei offenen Brückenschaltern aus, so existiert eine induzierte Gegenspannung, die mit dem Sollwert dann ebenfalls berücksichtigt wird. In diesem Betrieb (offene Brückenschalter, kein Stromfluss, aber induzierte Spannungen zwischen zwei beliebigen Motorphasen) beziehen sich die messbaren induzierten Spannungen nicht auf ein Potenzial (z. B. Masse), da kein Strom zu/von den Speiseanschlüssen fließt und die Motorwicklungen ebenfalls potenzialfrei sind (Sternpunkt ist potenzialfrei). Daher macht es steuergerätseitig Sinn, die emulierte Spannung zwischen zwei beliebigen Motorphasen zu messen, und folglich ist der konkrete Offset zur entsprechenden Spannungseinprägung letztendlich egal, solange zwischen zwei beliebigen Phasen die gemessene Spannung nicht größer wird als *v_{DC_Link}* zuzüglich der doppelten Diodenspannung.

Die Wahl einer Testspannung, die von der Motorsteuerung nicht erzeugbar ist, dient der Unterscheidbarkeit der zurückgemessenen Spannungspotenziale. Die Motorsteuerung kann auf die Speiseanschlüsse mittels der in ihr wirkenden Halbbrücken-Schalter nur die Zwischenkreisspannung oder das Ground-Potenzial aufschalten, die halbe Zwischenkreisspannung kann also nicht von der Motorsteuerung stammen, es handelt sich, wenn diese Spannung auf einer Phase gemessen wird, also um eine von der Motorsteuerung nicht angesteuerte Phase, die über geöffnete Halbbrücken-Schalter potenzialmäßig freigeschaltet ist.

Vorzugsweise ist vorgesehen, dass die Beaufschlagung der Speiseanschlüsse mit der Testspannung über eine Latenzzeit *t₃* erfolgt, dass der angesteuerte Zustand *S_{PH}(j)*=*0* eines Speiseanschlusses *j* erkannt wird, wenn der Betrag der Differenzspannung *v_{diff}(j)* zwischen der an dem Speiseanschluss *j* der Motorsteuerung gemessenen Ausgangsspannung *vᵢₙᵥ(j)* und der über die Lastanschlüsse aufgegebenen Testspannung nach der Latenzzeit *t₃* größer ist als ein vorbestimmter Spannungsschwellwert *v_{TH}.* Diese Maßnahme dient dazu, transiente Vorgänge in dem Lastemulator, insbesondere in der Emulatorleistungselektronik abklingen zu lassen, sodass bei der Auswertung der Spannungen ein stabiler und zuverlässiger Wert erhalten wird. Vorzugsweise wird die Latenzzeit *t₃* mindestens so lange bemessen, wie die Emulatorleistungselektronik benötigt, um die Vorgabe der Testspannung zuverlässig einzustellen.

Das zuvor beschriebene Erkennen der angesteuerten Phasen bzw. der angesteuerten Speiseanschlüsse und damit die Identifizierung einer blockkommutierten oder einer sinuskommutierten Ansteuerung durch die Motorsteuerung führt dazu, dass mit hoher Zuverlässigkeit und in richtiger Art und Weise der dreiphasige Elektromotor mit dem Lastemulator nachgebildet werden kann. Dies geschieht dadurch, dass nach Erkennung des angesteuerten Zustands *S_{PH}(j)*=*0* des Speiseanschlusses *j* der Motorsteuerung die Emulatorsteuerung die Emulatorleistungselektronik so ansteuert, dass über den nunmehr durch die Motorsteuerung angesteuerten Speiseanschluss *j* der von der Emulatorsteuerung berechnete Phasenstrom *iₑₘᵤₗₐₜₑ(j)* fließt, insbesondere wobei bei Erkennung von zwei gleichzeitig angesteuerten Speiseanschlüssen als Motormodell das Modell eines blockkommutierten Motors verwendet wird und wobei bei Erkennung von drei gleichzeitig angesteuerten Speiseanschlüssen als Motormodell das Modell eines sinuskommutierten Motors verwendet wird. Es kommt dabei nicht darauf an, ob es sich hierbei um zwei verschiedene Modelle des Elektromotors handelt, es kann genauso gut ein Modell vorliegen, was die entsprechenden Teilmodelle zur richtigen Behandlung der jeweiligen Situation umfasst.

Das hier vorgestellte Verfahren zur Nachbildung eines dreiphasigen Elektromotors ist gerade nicht beschränkt auf blockkommutierte Elektromotoren, vielmehr sollen auch Elektromotoren nachgebildet werden können, bei denen alle Phasen unterbrechungsfrei angesteuert werden, also mit einem berechneten Strom durch die Emulatorleistungselektronik beaufschlagt werden. Eine Weiterbildung des Verfahrens sieht daher vor, dass für eine beliebige Phase des Motors und damit für einen beliebigen Speiseeanschluss der Motorsteuerung sicher erkannt wird, ob die Phase bzw. der Speiseanschluss durch die Motorsteuerung weiter angesteuert wird oder nicht. Diese Frage stellt sich bei jedem Nulldurchgang des Stromes in einer Phase. Bei sinuskommutierter Ansteuerung bleibt jede Phase im angesteuerten Zustand, auch bei einem Nulldurchgang des Stromes, wohingegen bei blockkommutierter Ansteuerung bei einem Nulldurchgang des Stromes immer eine der zuvor angesteuerten Phasen in den nicht angesteuerten Zustand wechselt.

Es ist nun vorgesehen, dass von der Emulatorsteuerung der Übergang eines Speiseanschlusses *k* der Motorsteuerung vom angesteuerten Zustand *S_{PH}(k)*=*0* in den nicht angesteuerten Zustand *SP_{H}(k)*=*1* dadurch erkannt wird, dass in einem Zeitintervall *TI_{Vcalc,1},* in dem der von der Emulatorsteuerung berechnete Phasenstrom *iₑₘᵤₗₐₜₑ(k)* von einem vorgegebenen ersten Stromwert *i_{emulate,1}(k)* auf einen vorgegebenen zweiten Stromwert *i_{emulate,2}(k)* abfällt, das Zeitintegral *V_{Integral,1}* über die entsprechende gemessene Ausgangsspannung *vᵢₙᵥ(k)* des Speiseanschluss *k* der Motorsteuerung berechnet wird. Ist das Zeitintegral *V_{In-tegral,1}* größer ist als ein vorgegebener Spannungszeit-Schwellwert *V_{DiodeTH,1}(k),* dann ist die betrachtete Phase in den nicht angesteuerten Zustand gewechselt. Dies hat dann zur Folge, dass die als nicht angesteuert identifizierte Phase bzw. der korrespondierende Lastanschluss von der Emulatorleistungselektronik von dem Strom- in den Spannungsmodus wechselt, also nicht mehr mit einem berechneten Strom beaufschlagt wird, sondern mit einer berechneten Induktionsspannung, da die Phase seitens der Motorsteuerung freigeschaltet, also floatend ist.

Die Idee besteht darin, von dem Umstand Gebrauch zu machen, dass über einen nicht angesteuerten Speiseanschluss auch im nicht angesteuerten Zustand zunächst noch ein Strom fließt, der sich jedoch über von der Motorsteuerung stets umfassten Freilaufdioden des Motorsteuerung-Umrichters abbaut. Dabei fällt an den Freilaufdioden eine Spannung ab, typisch etwa 0,7 V. Diese Spannung kann über die Speiseanschlüsse der Motorsteuerung gemessen werden, was vorliegend der Fall ist. Bei einer angesteuerten Phase bzw. bei einem angesteuerten Speiseanschluss der Motorsteuerung mit einem Nulldurchgang des Stromes wäre die messbare Spannung an dem betreffenden Speiseanschluss der Motorsteuerung entweder praktisch Null oder sie entspräche *v_{DC_Link}.* Dieser Unterschied wird durch das zuvor beschriebene Verfahren ausgewertet.

Ein darauf aufbauende Weiterbildung des Verfahrens zeichnet sich dadurch aus, dass der vorgegebene erste Stromwert *i_{emulate,1}(k)* kleiner ist als der halbe maximale berechnete Stromwert des Phasenstroms *i_{emulate,}(k),* insbesondere kleiner ist als ein Viertel des maximalen berechneten Stromwertes des Phasenstroms *i_{emulate,}(k).* dadurch wird sichergestellt, dass der Strom sich tatsächlich auf einen Nulldurchgang zubewegt. Beispielsweise sollte bei einem 100 A-System *i_{emulate,}(k)* kleiner sein als 25 A. Ein sinnvoller Schwellwert konnte in der Praxis bei 100 A-Systemen sogar zwischen 1A und 2A gewählt werden. Bei Anwendungen im kleinen Leistungsbereich (z. B. Festplattenmotoren) kann dieser Schwellwert auch deutlich kleiner sein. Wichtig ist, dass im definierten Stromband die Spannung über die Freilaufdioden noch deutlich messbar ist, bevor sich der Strom komplett abgebaut hat.

Ferner ist vorgesehen, dass der vorgegebene zweite Stromwert *i_{emulate,2}(k)* ein Bruchteil des vorgegebenen ersten Stromwertes *i_{emulate,1}(k)* ist, vorzugsweise Dreiviertel des vorgegebenen ersten Stromwertes *i_{emulate,1}(k)* beträgt. Der vorgegebene zweite Stromwert *i_{emulate,2}(k)* sollte jedenfalls so groß gewählt werden, dass die Spannung über die Freilaufdioden nicht komplett einbrechen kann.

Es hat sich ferner als sinnvoll herausgestellt, dass der vorgegebene Spannungszeit-Schwellwert *V_{DiodeTH,1}(k)* dem Zeitintegral der halben Freilaufdiodenspannung einer von der Motorsteuerung umfassten Freilaufdiode ist. Als Integrationszeitraum wird hier auch das Zeitintervall *TI_{Vcalc,1}* herangezogen, in dem der von der Emulatorsteuerung berechnete Phasenstrom *iₑₘᵤₗₐₜₑ(k)* von dem vorgegebenen ersten Stromwert *i_{emulate,1}(k)* auf den vorgegebenen zweiten Stromwert *i_{emulate,2}(k)* abfällt. Der dabei entstehende Schwellwert ist hinreichend groß, um sich von einer solchen aufintegrierten Spannung zu unterscheiden, die an dem angesteuerten Speiseanschluss ggf. noch anliegt, wenn der Speiseanschluss über einen Leistungsschalter des Umrichters der Motorsteuerung auf das Nullpotenzial oder auf das High-Potenzial gezogen wird.

Die sichere Erkennung nicht angesteuerter Speiseanschlüsse ermöglicht eine interessante Ausgestaltung des Verfahrens, mit der auf eine beispielsweise abgeschaltete Motorsteuerung reagiert werden kann. Bei dieser Ausgestaltung des Verfahrens wird von der Emulatorsteuerung, wie zuvor beschrieben, der Übergang aller Speiseanschlüsse der Motorsteuerung vom angesteuerten Zustand *S_{PH}(k)*=*0* in den nicht angesteuerten Zustand *SP_{H}(k)*=*1* untersucht. Bei Erkennen des Übergangs wenigstens zweier Speiseanschlüsse der Motorsteuerung vom angesteuerten Zustand *S_{PH}(k)=0* in den nicht angesteuerten Zustand *SP_{H}(k)*=*1* wird die Emulatorleistungselektronik mit dem Schaltmittel hochohmig von den Speiseanschlüssen abgetrennt. Dann sind die Speiseanschlüsse der Motorsteuerung nur noch mit dem hochohmigen Widerstandsnetzwerk miteinander verbunden. Es ist dann weiterhin möglich, durch die Motorsteuerung Diagnose- und Initialisierungsroutinen durchführen zu lassen. Natürlich umfasst dies auch den Fall, dass alle drei Speiseanschlüsse der Motorsteuerung in den nicht angesteuerten Zustand *SP_{H}(k)*=*1* wechseln, der Motor trudelt dann aus. Alle Phasen befinden sich dann im Spannungsmodus, da die induzierte Spannung abgebildet werden muss. Wenn die Motordrehzahl nach Austrudeln des Motors zu Null wird, wird die Emulatorleistungselektronik mit dem Schaltmittel hochohmig von den Speiseanschlüssen abgetrennt.

Die eingangs beschriebene und hergeleitete Aufgabe ist bei dem Lastemulator, von dem die Erfindung ausgeht, entsprechend dadurch gelöst, dass der Lastemulator dreiphasig über seine Lastanschlüsse an die Speiseanschlüsse einer Motorsteuerung anschließbar ist und der Lastemulator eine Emulatorleistungselektronik und eine Emulatorsteuerung zur Steuerung der Emulatorleistungselektronik aufweist, wobei die Emulatorsteuerung die von der Motorsteuerung angesteuerten Speiseanschlüsse und nicht angesteuerten Speiseanschlüsse ermittelt, und die Emulatorleistungselektronik durch die Emulatorsteuerung so angesteuert wird, dass in den durch die Motorsteuerung angesteuerten Speiseanschlüssen von der Emulatorsteuerung auf Grundlage eines Motormodells berechnete Phasenströme *iₑₘᵤₗₐₜₑ* fließen und auf den von der Motorsteuerung nicht angesteuerten Speiseanschluss eine von der Emulatorsteuerung auf Grundlage eines Motormodells berechnete Phasenspannung *vₑₘᵤₗₐₜₑ* aufgegeben wird, und dass der Lastemulator ein Schaltmittel umfasst, mit dem die Emulatorleistungselektronik hochohmig von den Speiseanschlüssen abgeschaltet werden kann und mit dem die Emulatorleistungselektronik niederohmig an die Speiseanschlüsse zugeschaltet werden kann und wobei die Speiseanschlüsse über ein hochohmiges Widerstandsnetzwerk miteinander verbunden sind.

Der Lastemulator zeichnet sich in Anlehnung an das zuvor beschriebene Verfahren dadurch aus, dass die Emulatorsteuerung zur Simulation von ausgewählten Betriebszuständen des Elektromotors die Emulatorleistungselektronik und das Schaltmittel so ansteuert, dass die Emulatorleistungselektronik mit dem Schaltmittel hochohmig von den Speiseanschlüssen abgetrennt wird oder die bereits mit hochohmig von den Speiseanschlüssen abgetrennte Emulatorleistungselektronik mit dem Schaltmittel niederohmig an die Speiseanschlüsse zugeschaltet wird.

Vorzugsweise ist das hochohmige Widerstandsnetzwerk einer Sternschaltung von drei im Wesentlichen ohmschen Widerständen, wobei jedes der freien Enden der Sternschaltung mit jeweils einem anderen Speiseanschluss der Motorsteuerung verbunden ist.

Schließlich ist die Emulatorsteuerung so ausgestaltet, dass sie bei bestimmungsgemäßem Einsatz das vorbeschriebene Verfahren zur Nachbildung eines dreiphasigen Elektromotors mit dem Lastemulator ausführt.

Im Einzelnen gibt es nun eine Vielzahl von Möglichkeiten, das erfindungsgemäße Verfahren und die erfindungsgemäße Emulatorsteuerung auszugestalten und weiterzubilden. Dazu wird verwiesen einerseits auf die den unabhängigen Patentansprüchen nachgeordneten Patentansprüche, andererseits auf die folgende Beschreibung von Ausführungsbeispielen in Verbindung mit der Zeichnung. In der Zeichnung zeigen
- Fig. 1: eine aus dem Stand der Technik bekannte Anordnung aus Motorsteuerung und Lastemulator zur Durchführung eines Verfahrens zur Nachbildung eines dreiphasigen Elektromotors,
- Fig. 2: die Kommutierungsübergänge innerhalb einer elektrischen Umdrehung an den Speiseanschlüssen einer Motorsteuerung,
- Fig. 3: eine ausführliche Darstellung der Anordnung zur Durchführung des erfindungsgemäßen Verfahrens,
- Fig. 4: ein Zustandsdiagramm zur Erläuterung der Erfassung des Übergangs eines Speiseanschlusses der Motorsteuerung vom hochohmigen Zustand in den Spannungsmodus,
- Fig. 5: Kurvenverläufe gemessener Phasenspannungen und berechneter Phasenströme zwecks Erkennung des Übergangs einer Phase vom angesteuerten Zustand in den nicht angesteuerten Zustand,
- Fig. 6: ein Zustandsdiagramm zur Erläuterung der Vorgehensweise gemäß Fig. 5 und
- Fig. 7: ein Zustandsdiagramm zur Erläuterung des Übergangs in den hochohmigen Zustand.

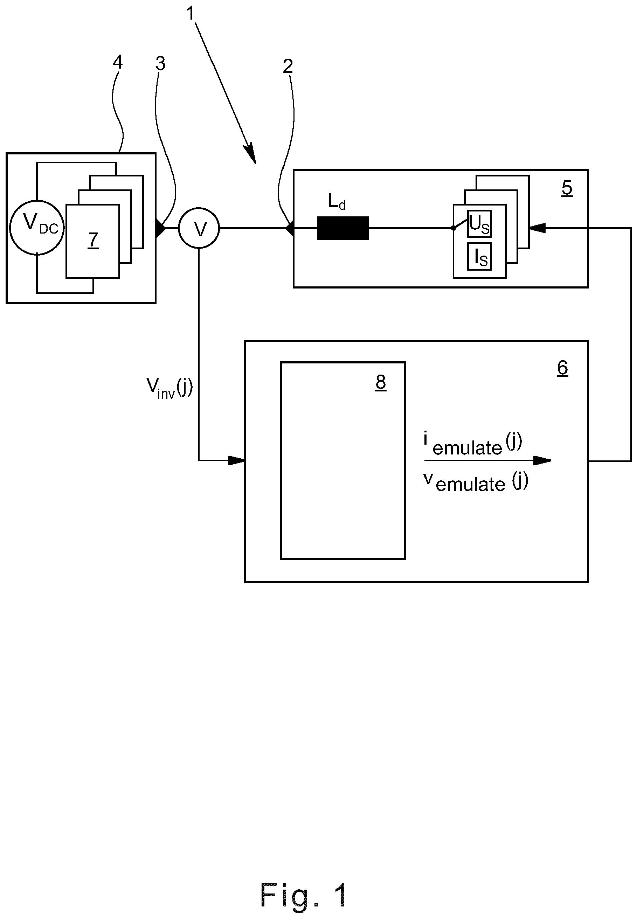

In Fig. 1 ist zunächst dargestellt eine aus dem Stand der Technik an sich bekannte Anordnung zur Durchführung eines Verfahrens zur Nachbildung eines dreiphasigen Elektromotors, bei dem es sich im Stand der Technik einschränkend um einen bürstenlosen Gleichstrommotor handelt. Die Anordnung weist zunächst einen Lastemulator 1 auf, wobei der Lastemulator 1 dreiphasig über seine Lastanschlüsse 2 an die Speiseanschlüsse 3 einer Motorsteuerung 4 angeschlossen ist. Der Lastemulator 1 weist eine Emulatorleistungselektronik 5 und eine Emulatorsteuerung 6 zur Steuerung der Emulatorleistungselektronik 5 auf. Die Motorsteuerung 4 umfasst im vorliegenden Fall selbst auch eine Leistungselektronik in Form eines dreiphasig angedeuteten Wechselrichters 7, der über eine Gleichspannungsquelle V_{DC} leistungsmäßig versorgt wird und durch entsprechende Schaltung der von dem Wechselrichter 7 umfassten Halbleiterschalter über seine Speiseanschlüsse 3 eine dreiphasige Wechsellast treibt.

Das Verfahren sieht vor, dass die Emulatorsteuerung 6 die von der Motorsteuerung 4 angesteuerten Speiseanschlüsse 3 und nicht angesteuerten Speiseanschlüsse 3 ermittelt, wobei die Emulatorleistungselektronik 5 durch die Emulatorsteuerung 6 so angesteuert wird, dass in den durch die Motorsteuerung 4 angesteuerten Speiseanschlüssen 3 von der Emulatorsteuerung 6 auf Grundlage eines Motormodells 8 berechnete Phasenströme *iₑₘᵤₗₐₜₑ* fließen und auf den von der Motorsteuerung 4 nicht angesteuerten Speiseanschluss 3 eine von der Emulatorsteuerung 6 auf Grundlage des Motormodells 8 berechnete Phasenspannung *vₑₘᵤₗₐₜₑ* aufgegeben wird. Es ist zu erkennen, dass die Emulatorleistungselektronik 5 zur Bewältigung dieser Aufgabe sowohl Stromquellen *Iₛ* als auch Spannungsquellen *Uₛ* aufweist, die entsprechend auf die Lastanschlüsse 2 der Emulatorleistungselektronik 5 geschaltet werden können, wobei dies im vorliegenden Fall mittelbar für jede Phase über eine Entkopplungsinduktivität *L_{d}* erfolgt.

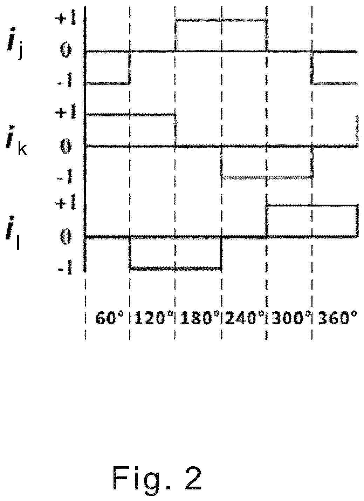

In Fig. 2 sind die sechs innerhalb einer elektrischen Umdrehung auftretenden Kommutierungsübergänge bei einem dreiphasigen blockkommutierten bürstenlosen Gleichstrommotor gezeigt, wobei die Kommutierungen jeweils im elektrischen Winkelabstand von 60° erfolgen. Es ist zu erkennen, dass der unangesteuerte Speiseanschluss nur in einem Kommutierungsintervall in einer Phase erhalten bleibt und danach sofort wieder in den angesteuerten Zustand überwechselt; die Phasen sind hier mit *ii, i₂* und *i₃* bezeichnet. "Unangesteuert" bedeutet hier, dass der jeweilige Speiseanschluss der Motorsteuerung potenzialmäßig offen ist, also weder durch die Leistungsschalter des Umrichters 7 auf Ground noch die positive Betriebsspannung *V_{DC}* gezogen wird. "Angesteuert" ist eine Phase bzw. der zugehörige Speiseanschluss 3 dann, wenn der Speiseanschluss von der Motorsteuerung auf ein definiertes elektrisches Potenzial gelegt wird und nicht potenzialmäßig offen - also nicht floatend ist. Von den beiden angesteuerten Speiseanschlüssen 3 der Motorsteuerung 4 wechselt ein Speiseanschluss in den nicht angesteuerten Zustand, während der andere angesteuerte Speiseanschluss im angesteuerten Zustand verbleibt. Über die blockkommutierte Ansteuerung wird so ein entsprechendes Drehfeld in dem bürstenlosen Gleichstrommotor erzeugt, mit dem dann ein entsprechendes Drehmoment aufgebracht werden kann.

In der EP 2940857 A1 wird ein Verfahren und eine Anordnung vorgestellt, mit denen solche blockkommutiert angesteuerten Motoren nachgebildet werden können. Ziel ist es vorliegend, das Verfahren so fortzubilden, dass es allgemein möglich ist, dreiphasige Elektromotoren nachzubilden, also auch solche Elektromotoren, deren Phasen durchgängig von der Motorsteuerung angesteuert sind, die also keine floatenden, unbestromten Phasen aufweisen. Natürlich weisen diese Motoren auch Nulldurchgänge des Stromes auf, genau wie dies bei blockkommutierten Motoren der Fall ist, jedoch sind ihre Phasen von der Motorsteuerung 4 durchgehend potenzialmäßig beschaltet.

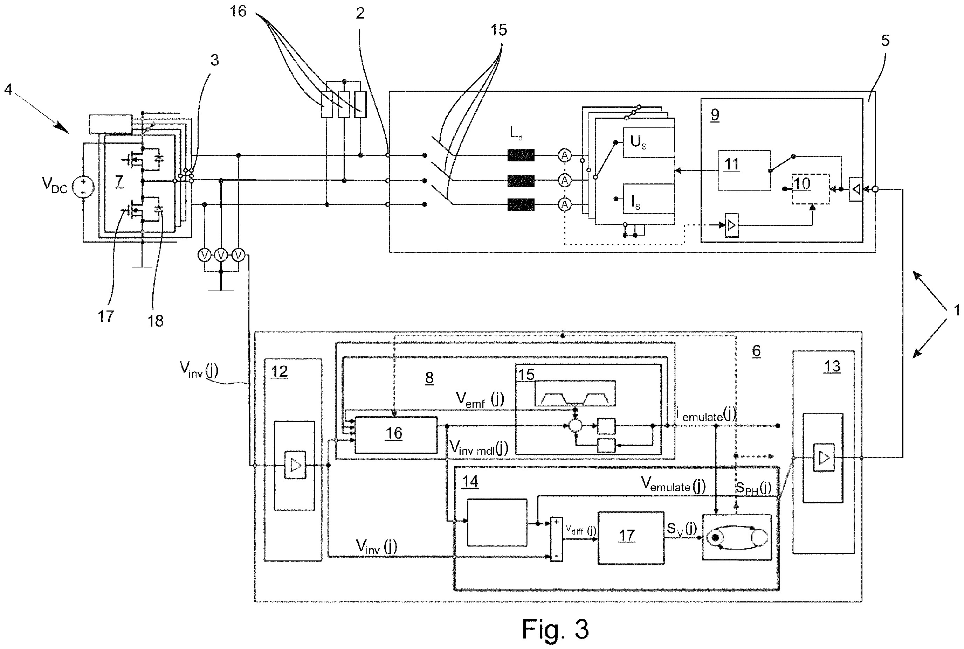

In Fig. 3 ist die Anordnung aus Fig. 1 zur Durchführung des erfindungsgemäßen Verfahrens mit der erfindungsgemäß eingerichteten Emulatorsteuerung 6 noch einmal in einem höheren Detaillierungsgrad dargestellt. Innerhalb der Emulatorleistungselektronik 5 ist ein Regler 9 gezeigt, der dafür sorgt, dass die vorgegebenen Phasenströme tatsächlich an den Lastanschlüssen 2 gemäß der Vorgabe aus der Emulatorsteuerung 6 eingestellt werden. Dazu wird innerhalb der Emulatorleistungselektronik 5 der jeweils interessierende Phasenstrom zurückgemessen und einem Regelungsalgorithmus 10 zwecks Bildung einer Regeldifferenz zugeführt. Über einen Modulator 11 wird der jeweils richtigen Phase ein vorgegebener Spannungswert oder ein vorgegebener Stromwert zugewiesen.

Die Emulatorsteuerung 6 ist in dem dargestellten Ausführungsbeispiel auf einem FPGA-Board realisiert, auf dem "fest verdrahtete" Schaltkreisstrukturen eine besonders schnelle Ausführbarkeit des nachfolgend beschriebenen Verfahrens gewährleisten. Über die einlesende Schnittstelle 12 werden die Ausgangsspannungen *vᵢₙᵥ(j),* die an den Speiseanschlüssen 3 der Motorsteuerung 4 gemessen werden, in die Emulatorsteuerung 6 eingelesen und dort verfügbar gemacht, es handelt sich also um echte Messgrößen. Über die Ausgangsschnittstelle 13 werden die berechneten Sollvorgaben für berechnete Phasenspannungen *vₑₘᵤₗₐₜₑ(j)* und für berechnete Phasenströme *iₑₘᵤₗₐₜₑ(j)* an die Emulatorleistungselektronik 5 ausgegeben.

Innerhalb der Emulatorsteuerung 6 ist darüber hinaus ein Zustandsautomat 14 realisiert, mit dem kommutierungsbedingte Zustandswechsel an den Speiseanschlüssen 3 der Motorsteuerung 4 erkannt werden. Der Zustand des Speiseanschlusses *j* wird im Folgenden grundsätzlich als *S_{PH}(j)* bezeichnet, wobei der Wert 1 für den nicht angesteuerten Zustand des Speiseanschlusses *j* steht und der Wert 0 für den angesteuerten Zustand des betreffenden Speiseanschlusses. Es kann auch bei einem nicht angesteuerten Speiseanschluss ein Strom fließen, nämlich über Freilaufdiode, bis er zum Erliegen kommt. In diesem Fall ist der Zustand 0. Auf den genaueren Aufbau und Inhalt der Emulatorsteuerung 6 kommt es hier im Einzelnen nicht an, diesbezügliche Informationen enthält die europäische Offenlegungsschrift EP 2940857 A1.

Der in Fig. 3 dargestellte Lastemulator 1 umfasst weiterhin ein Schaltmittel 15, mit dem die Emulatorleistungselektronik 5 hochohmig von denSpeiseanschlüssen 3 abgeschaltet werden kann. Es könnte genauso gut gesagt werden, dass mit dem Schaltmittel 15 die Emulatorleistungselektronik hochohmig von den Lastanschlüssen 2 abgeschaltet werden kann, was letztlich auch ein Abschalten der Emulatorleistungselektronik 5 von denSpeiseanschlüssen 3 bewirkt. Wichtig ist, dass die Emulatorleistungselektronik 5 nicht mehr wirksam mit der Motorsteuerung 4 verbunden ist und nicht auf die Motorsteuerung 4 elektrisch einwirken kann. Das Schaltmittel 15 umfasst hier insgesamt drei Halbleiterschalter, mit denen jede Phase separat hochohmig von den Lastanschlüssen 2 - und damit von den Speiseanschlüssen 3 der Motorsteuerung 4 - abgetrennt werden kann. Bei dem durch das Schaltmittel 15 erzielbaren "hochohmigen Zustand" eines Speiseanschlusses j nimmt *S_{PH}(j)* im Folgenden den Wert 2 an.

Umgekehrt kann die Emulatorleistungselektronik 5 mit dem Schaltmittel 15 natürlich auch niederohmig wieder an die Speiseanschlüsse 3 der Motorsteuerung 4 zugeschaltet werden. Die niederohmige Zuschaltung an die Speiseanschlüsse 3 der Motorsteuerung 4 ist dabei entscheidend, da es um die elektrisch wirksame Ankopplung der Emulatorleistungselektronik 5 an die Motorsteuerung 4 geht. Darüber hinaus sind die Lastanschlüsse 2 über ein hochohmiges Widerstandsnetzwerk 16 miteinander verbunden. Dies ist gleichbedeutend damit, dass die Speiseanschlüsse 3 der Motorsteuerung über das hochohmige Widerstandsnetzwerk 16 miteinander verbunden sind. Wie noch dargelegt werden wird, kommt es im Wesentlichen auf die elektrische Verbindung der Speiseanschlüsse 3 der Motorsteuerung 4 über das Widerstandsnetzwerk 16 an und zwar auch, wenn die Emulatorleistungselektronik 5 durch die Schaltmittel 15 hochohmig abgetrennt sind, sodass keine elektrisch wirksame Verbindung mehr zwischen der Motorsteuerung 4 und der Emulatorleistungselektronik 5 existiert.

Zur Simulation von ausgewählten Betriebszuständen des Elektromotors wird die Emulatorleistungselektronik 5 mit dem Schaltmittel 15 hochohmig von den Lastanschlüssen 2 abgetrennt oder es wird die bereits von den Lastanschlüssen 2 abgetrennte Emulatorleistungselektronik 5 mit dem Schaltmittel 15 niederohmig an die Lastanschlüsse 2 zugeschaltet. Es könnte genauso gut heißen, dass zur Simulation von ausgewählten Betriebszuständen des Elektromotors die Emulatorleistungselektronik 5 mit dem Schaltmittel 15 hochohmig von den Speiseanschlüssen 3 abgetrennt wird oder die bereits hochohmig von den Speiseanschlüssen 3 abgetrennte Emulatorleistungselektronik mit dem Schaltmittel 15 niederohmig an die Speiseanschlüsse 3 zugeschaltet wird. Im Ergebnis ist es jedenfalls so, dass das Schaltmittel 15 nicht die hochohmige Verbindung der Speiseanschlüsse 3 durch das hochohmige Widerstandsnetzwerk 16 beeinflusst.

Durch das immer wirksame mit den Speiseanschlüssen 3 der Motorsteuerung 4 verbundene Widerstandsnetzwerk kann auch auf solche Betriebsarten der Motorsteuerung reagiert werden, die jenseits des motorischen oder auch generatorischen Normalbetriebs liegen, also auch dann, wenn die Emulatorleistungselektronik 5 hochohmig von der Motorsteuerung 4 abgetrennt ist. Wenn die Motorsteuerung 4 zur Initialisierung einer Betriebsphase eine Spannung oder ein Spannungsmuster auf die Speiseanschlüsse 3 gibt, können diese aufgegebenen Spannungen über das Widerstandsnetzwerk 16 beispielsweise über andere Speiseanschlüsse 3 rückgemessen werden. Ein solches Beaufschlagen der Speiseanschlüsse mit einem Testmuster dient häufig der Identifizierung der äußeren Beschaltung der Speiseanschlüsse 3 durch die Motorsteuerung 4.

Im vorliegenden Fall ist das hochohmige Widerstandsnetzwerk 16 eine Sternschaltung von drei im Wesentlichen ohmschen Widerständen, wobei jedes der freien Enden der Sternschaltung mit jeweils einem anderen Speiseanschluss 3 der Motorsteuerung 4 verbunden ist. Wenn gesagt ist, dass die Widerstände im Wesentlichen ohm'sch sind, dann ist damit gemeint, dass es sich bei den Elementen des Widerstandsnetzwerkes 16 hier um Widerstände im praktischen fachüblichen elektrotechnischen Verständnis handelnd, wissend dass es ideale ohm'sche Widerstände nicht gibt, also jedes elektrische Bauelement selbstverständlich auch parasitäre induktive und kapazitive Eigenschaften aufweisen kann.

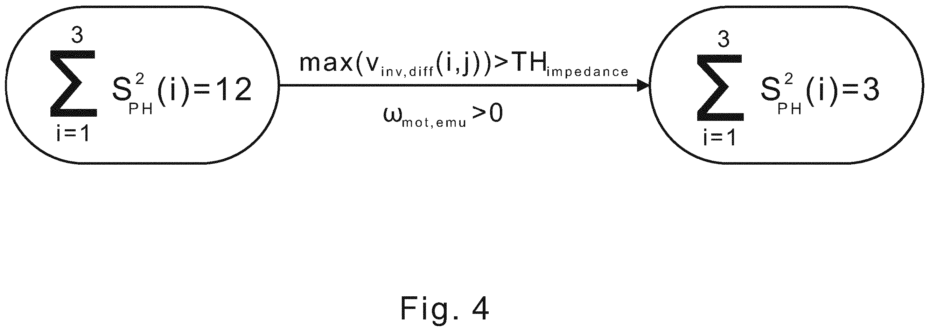

In Fig. 4 ist ein Ausführungsbeispiel gezeigt, bei dem die Emulatorleistungselektronik 5 zunächst hochohmig von den Lastanschlüssen 2 der Emulatorleistungselektronik 5 und damit auch hochohmig von den Speiseanschlüssen 3 der Motorsteuerung 4 abgetrennt ist. Es gilt also für alle Phasen *S_{PH}(i)*=2. Ein motorischer Motoranstart wird durch die Motorsteuerung 4 durch eine beginnende Ansteuerung der Speiseanschlüsse 3 erkannt, wenn zumindest eine der zwischen den Speiseanschlüssen i, j der Motorsteuerung 4 durch Messung ermittelten Ausgangsdifferenzspannungen *v_{inv,diff}(i, j)* größer als ist als ein vorbestimmter Spannungsschwellwert *TH_{imepdance}.* Es ist einleuchtend, dass messtechnisch erfassbare Differenzspannungen *v_{inv,diff}(i, j)* zwischen den Speiseanschlüssen 3 der Motorsteuerung 4 auf eine beginnende Ansteuerung des Motors hindeuten können. Ein generatorischer Motoranstart des Motors kann ebenfalls erkannt werden. Ausgangszustand ist wieder der, dass die Motorsteuerung 4 keinen Speiseanschluss 3 ansteuert und die Emulatorleistungselektronik 5 mit dem Schaltmittel 15 von den Speiseanschlüssen 3 der Motorsteuerung bzw. von den Lastanschlüssen 2 der Emulatorleistungselektronik 5 abgetrennt ist. Ein generatorischer Motoranstart wird dann erkannt, wenn die Motordrehzahl *ω_{mot,emu}* des Motormodells 8 ausgewertet wird und die Motordrehzahl *ω_{mot,emu}* ungleich Null ist, was ebenfalls in Fig. 4 dargestellt ist.

Das Ergebnis des - motorisch oder generatorisch - erkannten Motoranstartes ist, dass die Emulatorleistungselektronik 5 mit dem Schaltmittel 15 niederohmig an die Lastanschlüsse 2 - und damit an die Speiseanschlüsse 3 - zugeschaltet wird und die Emulatorsteuerung 6 die Lastanschlüsse 2 der Emulatorleistungselektronik 5 so ansteuert, dass die Lastanschlüsse 2 und damit die Speiseanschlüsse 3 mit einer Spannung beaufschlagt werden, alle Phasen der Emulatorleistungselektronik 5 also im Spannungsmodus arbeiten. Für die Spannung, mit der die Lastanschlüsse 2 durch die Emulatorleistungselektronik 5 beaufschlagt werden, wird eine Testspannung verwendet, die von der Motorsteuerung 4 über die Speiseanschlüsse 3 nicht auf die Lastanschlüsse 2 gegeben werden kann, wobei die Testspannung hier der halben Zwischenkreisspannung *v_{DC_Link}* der Motorsteuerung 4 entspricht. Die Wahl einer solchen Testspannung gestattet es herauszufinden, welche der Speiseanschlüsse 3 von der Motorsteuerung 4 angesteuert werden. Wenn von der Motorsteuerung 4 ein Speiseanschluss 3 potenzialmäßig offen - floatend - bleibt, kann die seitens der Emulatorleistungselektronik 5 aufgegebene Testspannung von der Emulatorsteuerung 6 zurückgemessen werden. Andernfalls würde die von der Motorsteuerung 4 aufgegebene Spannung die maßgebliche und über die Speiseanschlüsse 3 von der Emulatorsteuerung 6 rückgemessene Spannung sein.

Die Beaufschlagung der Lastanschlüsse 2 mit der Testspannung erfolgt über eine Latenzzeit *t₃.* Der angesteuerte Zustand *S_{PH}(j)*=*0* eines Speiseanschlusses *j* wird dann erkannt, wenn der Betrag der Differenzspannung *v_{diff}(j)* zwischen der an dem Speiseanschluss *j* der Motorsteuerung 4 gemessenen Ausgangsspannung *vᵢₙᵥ(j)* und der über die Lastanschlüsse 2 aufgegebenen Testspannung nach der Latenzzeit *t₃* größer ist als ein vorbestimmter Spannungsschwellwert *v_{TH}*. Die Latenzzeit *t₃* ist mindestens so lang bemessen, wie die Emulatorleistungselektronik 5 benötigt, um die Vorgabe der Testspannung zuverlässig einzustellen.

Nach Erkennung des angesteuerten Zustands *S_{PH}(j)*=*0* des Speiseanschlusses *j* der Motorsteuerung 4 steuert die Emulatorsteuerung 6 die Emulatorleistungselektronik 5 so an, dass über den nunmehr durch die Motorsteuerung 4 angesteuerten Speiseanschluss *j* der von der Emulatorsteuerung 6 berechnete Phasenstrom *iₑₘᵤₗₐₜₑ(j)* fließt. Bei Erkennung von zwei gleichzeitig angesteuerten Speiseanschlüssen 3 kann davon ausgegangen werden, dass die Ansteuerung durch die Motorsteuerung 4 blockkommutiert erfolgt, und bei Erkennung von drei gleichzeitig angesteuerten Speiseanschlüssen 3 kann davon ausgegangen werden, dass eine sinuskommutierten Ansteuerung durch die Motorsteuerung 4 erfolgt.

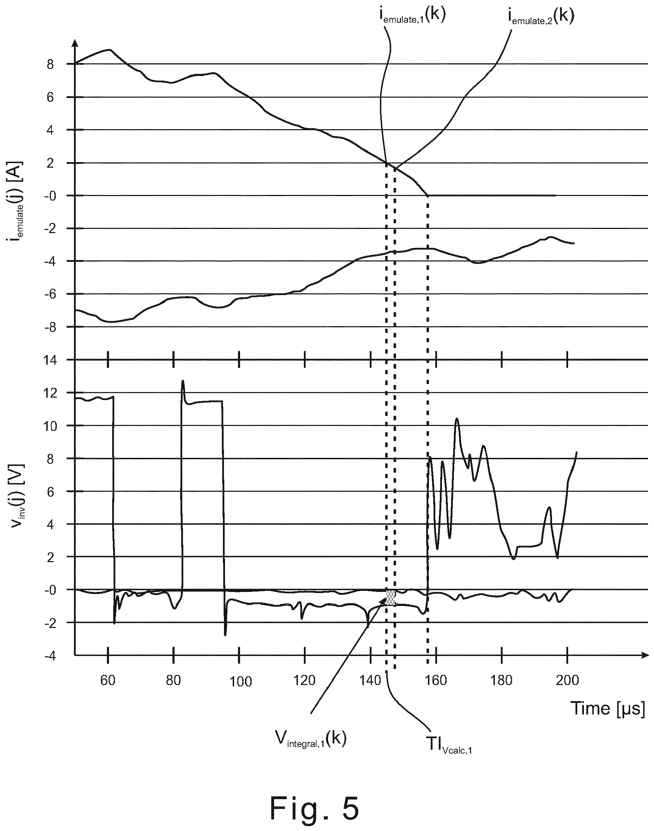

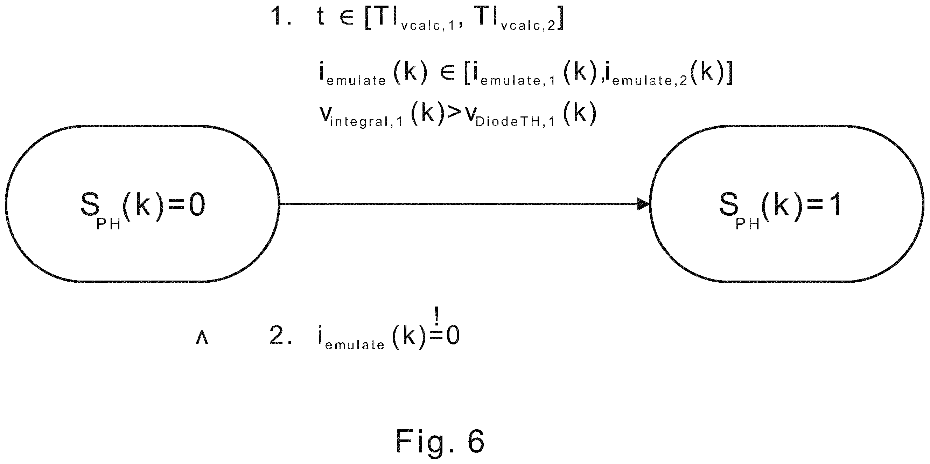

Die Fig. 5 und 6 beschreiben die Erkennung des Übergangs einer Phase vom angesteuerten Zustand *S_{PH}(j)*=*0* in den nicht angesteuerten Zustand *S_{PH}(j)*=*1.* Hier muss ein Kriterium gefunden werden, das eine zuverlässige und eindeutige Auswertung geeigneter Zustandsgrößen ermöglicht. Es genügt beispielsweise nicht, einfach nur Nulldurchgänge des Stromes in einzelnen Phasen zu beobachten, da derartige Stromnulldurchgänge auch bei sinuskommutierten Motoren vorliegen, die durchgehend in allen Phasen angesteuert sind.

In Fig. 5 sind zunächst dargestellt die Verläufe zweier Phasenspannungen und zweier Phasenströme, wobei der Verlauf der dritten Phasenspannung und der Verlauf des dritten Phasenstroms aus Gründen der Übersichtlichkeit weggelassen worden sind. Im unteren Abschnitt des Diagramms in Fig. 5 ist der gemessene Verlauf der beiden Phasenspannungen *vᵢₙᵥ* in Volt aufgetragen, im oberen Abschnitt des Diagramms sind die korrespondierenden berechneten Phasenströme *iₑₘᵤₗₐₜₑ* in Ampere aufgetragen. Über beide Verläufe hat die Emulatorsteuerung 6 Kenntnis, *iₑₘᵤₗₐₜₑ* ist von ihr selbst berechnet worden, der Verlauf der Phasenspannungen *vᵢₙᵥ* liegt als Messgröße vor, siehe Fig. 3.

Von der Emulatorsteuerung 6 wird der Übergang eines Speiseanschlusses k der Motorsteuerung 4 vom angesteuerten Zustand *S_{PH}(k)*=*0* in den nicht angesteuerten Zustand *SP_{H}(k)*=*1* durch Beobachtung des Phasenstroms *iₑₘᵤₗₐₜₑ(k)* erkannt. Es wird das Zeitintervall *TI_{Vcalc,1}* betrachtet, in dem der von der Emulatorsteuerung 6 berechnete Phasenstrom *iₑₘᵤₗₐₜₑ(k)* von einem vorgegebenen ersten Stromwert *i_{emulate,1}(k)* auf einen vorgegebenen zweiten Stromwert *i_{emu-late,2}(k)* abfällt. Das Durchschreiten dieser Grenzwerte definiert also das Zeitintervall *TI_{Vcalc,1}.* In diesem Zeitintervall wird dann das Zeitintegral *V_{Integral,1}* über die entsprechende gemessene Ausgangsspannung *vᵢₙᵥ(k)* des Speiseanschluss *k* der Motorsteuerung 4 berechnet. Ist das Zeitintegral *V_{Integral,1}* größer als ein vorgegebener Spannungszeit-Schwellwert *V_{DiodeTH,1}(k),* dann ist der Übergang der Phase in den nicht angesteuerten Zustand *SP_{H}(k)*=*1* erkannt.

Bei diesem Verfahren wird ausgenutzt, dass der Umrichter 7 der Motorsteuerung 4 Halbleiterschalter 17 mit zur Betriebsstromrichtung antiparallel geschalteten Freilaufdioden 18 aufweist (Fig. 3).Wird ein Speiseanschluss 3,k der Motorsteuerung nicht mehr angesteuert, ist der betreffende Strompfad potenzialmäßig frei, wobei der Strom in dem Strompfad k aufgrund der Motorinduktivität nur stetig abnehmen kann und sich über die Freilaufdioden 18 abbaut. Während diese Vorgangs fällt an der betroffenen Freilaufdiode eine Durchlassspannung von etwa 0,7 V ab, die an dem betreffenden Speiseanschluss anliegt und gemessen wird. Im Gegensatz dazu läge bei einem angesteuerten Speiseanschluss 3,k mit Stromnulldurchgang eine definierte Spannung von 0 V an dem betreffenden Speiseanschluss, da der low-side-Halbbrückenschalter 17 eine elektrische Verbindung zum Ground-Potenzial herstellte. Im ersten Fall ist die Spannungszeitfläche im Zeitintervall *TI_{Vcalc,1}* ungleich Null, im zweiten Fall ist sie praktisch gleich Null. Hier ist der Spannungszeit-Schwellwert *V_{DiodeTH,1}(k)* auf Basis der halben Freilaufdiodenspannung von 0,35 V über das Zeitintervall *TI_{Vcalc,1}* durch Integration berechnet worden.

In dem in Fig. 5 dargestellten Ausführungsbeispiel beträgt der vorgegebene erste Stromwert *i_{emulate,1}(k)* 2 A und entspricht damit etwa einem Viertel des maximalen berechneten Stromwertes des Phasenstroms *i_{emulate,}(k).* Der vorgegebene zweite Stromwert *i_{emulate,2}(k)* beträgt in dem Beispiel 1,75 A und entspricht damit etwa Dreiviertel des vorgegebenen ersten Stromwertes *i_{emu-late,1}(k).*

In Fig. 6 ist die Erkennung des Zustandsübergangs vom angesteuerten Zustand *S_{PH}(j)*=*0* in den nicht angesteuerten Zustand *S_{PH}(j)*=*1* formal in Form eines Zustandsdiagramms dargestellt, wie es im Rahmen des Zustandsautomaten 14 realisiert ist. Wenn der Phasenstrom zu Null wird und die Vorbedingung auf Grundlage der Spannungszeitfläche erfüllt ist, erfolgt der Zustandswechsel.

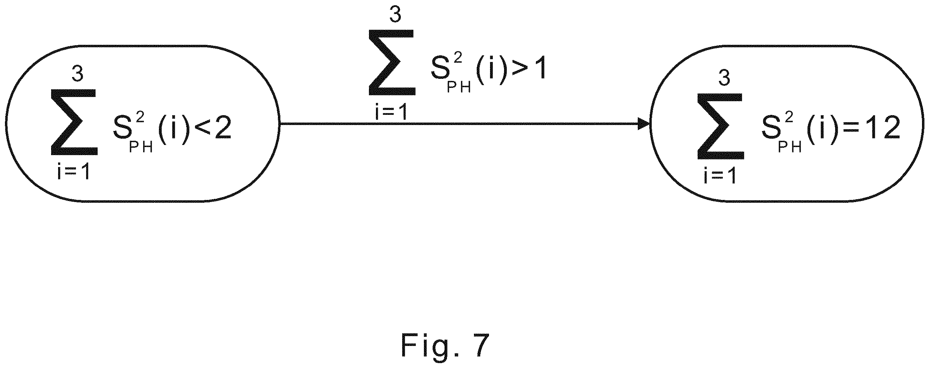

In Fig. 7 ist schließlich dargestellt der Übergang aller Phasen in den hochohmigen Zustand, wozu die zuvor beschriebene Erkennung des nicht angesteuerten Zustands eines Speiseanschlusses 3 bzw. einer Phase herangezogen wird. Von der Emulatorsteuerung 6 wird der Übergang aller Speiseanschlüsse der Motorsteuerung 4 überwacht und damit auch ein Zustandswechsel vom angesteuerten Zustand *S_{PH}(k)*=*0* in den nicht angesteuerten Zustand *SP_{H}(k)*=*1* erkannt. Bei Erkennen des Übergangs wenigstens zweier Speiseanschlüsse 3 der Motorsteuerung 4 vom angesteuerten Zustand *S_{PH}(k)=0* in den nicht angesteuerten Zustand *SP_{H}(k)*=*1* wird die Emulatorleistungselektronik 5 mit dem Schaltmittel 15 hochohmig von den Speiseanschlüssen 3 abgetrennt. Dies erfolgt hier durch Abtrennung von den Lastanschlüssen 2, die mit den Speiseanschlüssen 3 stets verbunden sind. Hintergrund dieses Zustandswechsels ist die Erkenntnis, dass bei zwei nicht angesteuerten Speiseanschlüssen 3 auch in der dritten Phase kein Strom fließen kann, so dass hier kein sinnvoller Betriebszustand vorliegt.

### Bezugszeichen

- 1.: Lastemulator
- 2.: Lastanschlüsse
- 3.: Speiseanschlüsse
- 4.: Motorsteuerung
- 5.: Emulatorleistungselektronik
- 6.: Emulatorsteuerung
- 7.: Umrichter
- 8.: Motormodell
- 9.: Regler
- 10.: Regelungsalgorithmus
- 11.: Modulator
- 12.: einlesende Schnittstelle
- 13.: Ausgangsschnittstelle
- 14.: Zustandsautomat
- 15.: Schaltmittel
- 16.: Widerstandsnetzwerk
- 17.: Halbleiterschalter
- 18.: Freilaufdiode

## Patentansprüche

1. Verfahren zur Nachbildung eines dreiphasigen Elektromotors mit einem Lastemulator (1), wobei der Lastemulator (1) dreiphasig über seine Lastanschlüsse (2) an die Speiseanschlüsse (3) einer Motorsteuerung (4) angeschlossen ist und der Lastemulator (1) eine Emulatorleistungselektronik (5) und eine Emulatorsteuerung (6) zur Steuerung der Emulatorleistungselektronik (5) aufweist, wobei die Emulatorsteuerung (6) die von der Motorsteuerung (4) angesteuerten Speiseanschlüsse (3) und nicht angesteuerten Speiseanschlüsse (3) ermittelt, und die Emulatorleistungselektronik (5) durch die Emulatorsteuerung (6) so angesteuert wird, dass in den durch die Motorsteuerung (4) angesteuerten Speiseanschlüssen (3) von der Emulatorsteuerung (6) auf Grundlage eines Motormodells (8) berechnete Phasenströme *iₑₘᵤₗₐₜₑ* fließen und auf den von der Motorsteuerung (4) nicht angesteuerten Speiseanschluss (3) eine von der Emulatorsteuerung auf Grundlage eines Motormodells (8) berechnete Phasenspannung *vₑₘᵤₗₐₜₑ* aufgegeben wird,
**dadurch gekennzeichnet,**
**dass** der Lastemulator (1) ein Schaltmittel (15) umfasst, mit dem die Emulatorleistungselektronik (5) hochohmig von den Speiseanschlüssen (3) abgeschaltet werden kann und mit dem die Emulatorleistungselektronik (5) niederohmig an die Speiseanschlüsse (3) zugeschaltet werden kann, sodass es möglich ist, die Emulatorleistungselektronik (5) wirksam elektrisch von der Motorsteuerung (4) zu trennen, wodurch eine Wechselwirkung zwischen der Motorsteuerung (4) und der Emulatorleistungselektronik (5) unterbunden wird, und wobei die Speiseanschlüsse (3) über ein hochohmiges Widerstandsnetzwerk (16) miteinander verbunden sind,
**dass** zur Simulation von ausgewählten Betriebszuständen des Elektromotors die Emulatorleistungselektronik (5) mit dem Schaltmittel (15) hochohmig von den Speiseanschlüssen (3) abgetrennt wird oder die bereits hochohmig von den Speiseanschlüssen (3) abgetrennte Emulatorleistungselektronik (5) mit dem Schaltmittel (15) niederohmig an die Speiseanschlüsse (3) zugeschaltet wird.

2. Verfahren nach Anspruch 1, **dadurch gekennzeichnet, dass** als hochohmiges Widerstandsnetzwerk (16) eine Sternschaltung von drei im Wesentlichen ohmschen Widerständen gewählt wird, wobei jedes der freien Enden der Sternschaltung mit jeweils einem anderen Speiseanschluss (3) der Motorsteuerung (4) verbunden ist.

3. Verfahren nach Anspruch 1 oder 2, **dadurch gekennzeichnet, dass** als Ausgangszustand die Motorsteuerung (4) keinen Speiseanschluss (3) ansteuert und die Emulatorleistungselektronik (5) mit dem Schaltmittel (15) hochohmig von den Speiseanschlüssen (3) abgetrennt ist, dass ein motorischer Motoranstart durch eine beginnende Ansteuerung der Speiseanschlüsse (3) durch die Motorsteuerung (4) erkannt wird, wenn zumindest eine der zwischen den Speiseanschlüssen *(3*, *i, j*) der Motorsteuerung (4) durch Messung ermittelten Ausgangsdifferenzspannungen *v_{inv,diff} (i,j)* größer ist als ein vorbestimmter Spannungsschwellwert *TH_{impedance}.*

4. Verfahren nach einem der Ansprüche 1 bis 3, **dadurch gekennzeichnet, dass** als Ausgangszustand die Motorsteuerung (4) keinen Speiseanschluss (3) ansteuert und die Emulatorleistungselektronik (5) mit dem Schaltmittel (15) hochohmig von den Speiseanschlüssen (3) abgetrennt ist, dass ein generatorischer Motoranstart erkannt wird, wenn die Motordrehzahl *ω_{mot,emu}* des Motormodells (8) ausgewertet wird und die Motordrehzahl *ω_{mot,emu}* ungleich Null ist.

5. Verfahren nach Anspruch 3 oder 4, **dadurch gekennzeichnet, dass** bei erkanntem motorischen oder generatorischen Motoranstart die Emulatorleistungselektronik (5) mit dem Schaltungsmittel (15) niederohmig an die Speiseanschlüsse (3) zugeschaltet wird und die Emulatorsteuerung (6) die Lastanschlüsse (2) der Emulatorleistungselektronik (5) so ansteuert, dass die Lastanschlüsse (2) mit einer Spannung beaufschlagt werden.

6. Verfahren nach Anspruch 5, **dadurch gekennzeichnet, dass** die Emulatorsteuerung (6) die Lastanschlüsse (2) der Emulatorleistungselektronik (5) so ansteuert, dass die Speiseanschlüsse (3) mit einer Testspannung beaufschlagt werden, wobei die Testspannung so gewählt wird, dass diese von der Zwischenkreisspannung und dem Ground-Potenzial unterscheidbar ist, welche durch die Motorsteuerung (4) auf die Speiseanschlüsse gegeben werden können, insbesondere wobei die Testspannung der halben Zwischenkreisspannung *v_{DC_Link}* der Motorsteuerung (4) zuzüglich der simulierten induzierten Gegenspannungen in der entsprechenden Motorphase entspricht.

7. Verfahren nach Anspruch 6, **dadurch gekennzeichnet, dass** die Beaufschlagung der Speiseanschlüsse (3) mit der Testspannung über eine Latenzzeit *t₃* erfolgt, dass der angesteuerte Zustand *S_{PH}(j)*=*0* eines Speiseanschlusses *j* erkannt wird, wenn der Betrag der Differenzspannung *v_{diff}(j)* zwischen der an dem Speiseanschluss *j* der Motorsteuerung (4) gemessenen Ausgangsspannung *vᵢₙᵥ(j)* und der über die Lastanschlüsse (2) aufgegebenen Testspannung nach der Latenzzeit *t₃* größer ist als ein vorbestimmter Spannungsschwellwert *VTH.*

8. Verfahren nach Anspruch 7, **dadurch gekennzeichnet, dass** die Latenzzeit *t₃* mindestens so lang bemessen wird, wie die Emulatorleistungselektronik (5) benötigt, um die Vorgabe der Testspannung zuverlässig einzustellen.

9. Verfahren nach Anspruch 7 oder 8, **dadurch gekennzeichnet, dass** nach Erkennung des angesteuerten Zustands *S_{PH}(j)*=*0* des Speiseanschlusses *j* der Motorsteuerung (4) die Emulatorsteuerung (6) die Emulatorleistungselektronik (5) so ansteuert, dass über den nunmehr durch die Motorsteuerung (4) angesteuerten Speiseanschluss *j* der von der Emulatorsteuerung (6) berechnete Phasenstrom *iₑₘᵤₗₐₜₑ(j)* fließt, insbesondere wobei bei Erkennung von zwei gleichzeitig angesteuerten Speiseanschlüssen (3) als Motormodell (8) das Modell eines blockkommutierten Motors verwendet wird und wobei bei Erkennung von drei gleichzeitig angesteuerten Speiseanschlüssen (3) als Motormodell (8) das Modell eines sinuskommutierten Motors verwendet wird.

10. Verfahren nach einem der Ansprüche 1 bis 9, **dadurch gekennzeichnet, dass** von der Emulatorsteuerung (6) der Übergang eines Speiseanschlusses *k* der Motorsteuerung (4) vom angesteuerten Zustand *S_{PH}(k)*=*0* in den nicht angesteuerten Zustand *SP_{H}(k)*=*1* dadurch erkannt wird, dass in einem Zeitintervall *TI_{Vcalc,1},* in dem der von der Emulatorsteuerung (6) berechnete Phasenstrom *iₑₘᵤₗₐₜₑ(k)* von einem vorgegebenen ersten Stromwert *i_{emulate,1}(k)* auf einen vorgegebenen zweiten Stromwert *i_{emulate,2}(k)* abfällt, das Zeitintegral *V_{Integral,1}* über die entsprechende gemessene Ausgangsspannung *vᵢₙᵥ(k)* des Speiseanschluss *k* der Motorsteuerung (4) berechnet wird und das Zeitintegral *V_{Integral,1}* größer ist als ein vorgegebener Spannungszeit-Schwellwert *V_{DiodeTH,1}(k).*

11. Verfahren nach Anspruch 10, **dadurch gekennzeichnet, dass** der vorgegebene erste Stromwert *i_{emulate,1}(k)* kleiner ist als der halbe maximale berechnete Stromwert des Phasenstroms *iₑₘᵤₗₐₜₑ,(k),* insbesondere kleiner ist als ein Viertel des maximalen berechneten Stromwertes des Phasenstroms *i_{emulate,}(k)* und/oder dass der vorgegebene zweite Stromwert *i_{emulate,2}(k)* ein Bruchteil des vorgegebenen ersten Stromwertes *i_{emulate,1}(k)* ist, vorzugsweise Dreiviertel des vorgegebenen ersten Stromwertes *i_{emulate,1}(k)* beträgt und/oder dass der vorgegebene Spannungszeit-Schwellwert *V_{DiodeTH,1}(k)* dem Zeitintegral *V_{Integral,1}* der halben Freilaufdiodenspannung einer von der Motorsteuerung (4) umfassten Freilaufdiode (18) ist.

12. Verfahren nach Anspruch 10 oder 11, **dadurch gekennzeichnet, dass** von der Emulatorsteuerung (6) der Übergang aller Speiseanschlüsse der Motorsteuerung (4) vom angesteuerten Zustand *S_{PH}(k)=0* in den nicht angesteuerten Zustand *S_{PH}(k)*=*1* untersucht wird und bei Erkennen des Übergangs wenigstens zweier Speiseanschlüsse (3) der Motorsteuerung (4) vom angesteuerten Zustand *S_{PH}(k)*=*0* in den nicht angesteuerten Zustand *SP_{H}(k)*=*1* die Emulatorleistungselektronik (5) mit dem Schaltmittel (15) hochohmig von den Lastanschlüssen (2) abgetrennt wird.

13. Lastemulator (1) zur Nachbildung eines dreiphasigen Elektromotors, wobei der Lastemulator (1) dreiphasig über seine Lastanschlüsse (2) an die Speiseanschlüsse (3) einer Motorsteuerung (4) anschließbar ist und der Lastemulator (1) eine Emulatorleistungselektronik (5) und eine Emulatorsteuerung (6) zur Steuerung der Emulatorleistungselektronik (5) aufweist, wobei die Emulatorsteuerung (6) die von der Motorsteuerung (4) angesteuerten Speiseanschlüsse (3) und nicht angesteuerten Speiseanschlüsse (3) ermittelt, und die Emulatorleistungselektronik (5) durch die Emulatorsteuerung (6) so angesteuert wird, dass in den durch die Motorsteuerung (4) angesteuerten Speiseanschlüssen (3) von der Emulatorsteuerung (6) auf Grundlage eines Motormodells (8) berechnete Phasenströme *iₑₘᵤₗₐₜₑ* fließen und auf den von der Motorsteuerung (4) nicht angesteuerten Speiseanschluss (3) eine von der Emulatorsteuerung auf Grundlage eines Motormodells (8) berechnete Phasenspannung *Vemulate* aufgegeben wird,
**dadurch gekennzeichnet,**
**dass** der Lastemulator (1) ein Schaltmittel (15) umfasst, mit dem die Emulatorleistungselektronik (5) hochohmig von den Speiseanschlüssen (3) abgeschaltet werden kann und mit dem die Emulatorleistungselektronik (5) niederohmig an die Speiseanschlüsse (3) zugeschaltet werden kann, sodass es möglich ist, die Emulatorleistungselektronik (5) wirksam elektrisch von der Motorsteuerung (4) zu trennen, wodurch eine Wechselwirkung zwischen der Motorsteuerung (4) und der Emulatorleistungselektronik (5) unterbunden wird, und wobei die Speiseanschlüsse (3) über ein hochohmiges Widerstandsnetzwerk (16) miteinander verbunden sind.

14. Lastemulator (1) nach Anspruch 13, **dadurch gekennzeichnet, dass** die Emulatorsteuerung (6) zur Simulation von ausgewählten Betriebszuständen des Elektromotors die Emulatorleistungselektronik (5) und das Schaltmittel (15) so ansteuert, dass die Emulatorleistungselektronik (5) mit dem Schaltmittel (15) hochohmig von den Speiseanschlüssen (3) abgetrennt wird oder die bereits mit hochohmig von den Speiseanschlüssen (3) abgetrennte Emulatorleistungselektronik (5) mit dem Schaltmittel (15) niederohmig an die Speiseanschlüssen (3) zugeschaltet wird.

15. Lastemulator (1) nach Anspruch 13 oder 14, **dadurch gekennzeichnet, dass** das hochohmige Widerstandsnetzwerk (16) eine Sternschaltung von drei im Wesentlichen ohmschen Widerständen ist, wobei jedes der freien Enden der Sternschaltung mit jeweils einem anderen Speiseanschluss (3) der Motorsteuerung (4) verbunden ist.

16. Lastemulator (1) nach einem der Ansprüche 13 bis 15, **dadurch gekennzeichnet, dass** die Emulatorsteuerung (6) so ausgestaltet ist, dass sie bei bestimmungsgemäßem Einsatz das Verfahren gemäß dem Kennzeichnungsteil wenigstens eines Anspruchs der Ansprüche 3 bis 12 ausführt

## Claims

1. A method for simulating a three-phase electric motor by means of a load emulator (1), the load connections (2) of the load emulator (1) being connected in three phases to the feed connections (3) of a motor controller (4) and the load emulator (1) comprising emulator power electronics (5) and an emulator controller (6) for controlling the emulator power electronics (5), the emulator controller (6) determining the feed connections (3) controlled by the motor controller (4) and the non-controlled feed connections (3), and the emulator power electronics (5) being actuated by the emulator controller (6) such that phase currents *iₑₘᵤₗₐₜₑ* calculated by the emulator controller (6) on the basis of a motor model (8) flow in the feed connections (3) actuated by the motor controller (4), and that a phase voltage *Vₑₘᵤₗₐₜₑ* calculated by the emulator controller on the basis of a motor model (8) is applied to the feed connection (3) not actuated by the motor controller (4),
**characterized in that**
the load emulator (1) comprises a switching means (15) by means of which the emulator power electronics (5) can be disconnected with high impedance from the feed connections (3) and by means of which the emulator power electronics (5) can be connected with low impedance to the feed connections (3), so that it is possible to effectively electrically disconnect the emulator power electronics (5) from the motor controller (4), whereby an interaction between the motor controller (4) and the emulator power electronics (5) is prevented, and wherein the feed connections (3) are connected to each other by means of a high-impedance resistor network (16),
and that for simulating selected operating states of the electric motor, the emulator power electronics (5) are disconnected with high impedance from the feed connections (3) by means of the switching means (15), or the emulator power electronics (5) already disconnected at high impedance from the feed connections (3) are connected to the feed connections (3) at low impedance by means of the switching means (15).

2. The method according to claim 1, **characterized in that** a star connection of three substantially ohmic resistors is selected as the high-impedance resistor network (16), wherein each of the free ends of the star connection is connected to a different feed connection (3) of the motor controller (4).

3. The method according to claim 1 or 2, **characterized in that** in the initial state of the motor controller (4), no feed connection (3) is actuated and the emulator power electronics (5) are disconnected with high impedance from the feed connections (3) by means of the switching means (15), and that a motor being started as a motor by beginning the actuating of the feed connections (3) is detected by the motor controller (4) when at least one of the initial differential voltages *v_{inv,diff} (i,j)* between the feed connections (3, *i, j*) of the motor controller (4) detected by measuring is greater than a predetermined voltage threshold *THimpedance.*

4. The method according to any one of the claims 1 through 3, **characterized in that** in the initial state, the motor controller (4) does not actuate any of the feed connections (3) and the emulator power electronics (5) are disconnected with high impedance from the feed connections (3) by means of the switching means (15), and that a motor being started as a generator is detected when the motor speed *ω_{mot,emu}* of the motor model (8) is evaluated and the motor speed *ω_{mot,emu}* is not equal to zero.

5. The method according to claim 3 or 4, **characterized in that** when a motor being started as a motor or as a generator is detected, the emulator power electronics (5) are connected to the feed connections (3) with low impedance by means of the switching means (15), and the emulator controller (6) actuates the load connections (2) of the emulator power electronics (5) such that a voltage is applied to the load connections (2).

6. The method according to claim 5, **characterized in that** the emulator controller (6) actuates the load connections (2) of the emulator power electronics (5) so that a test voltage is applied to the feed connections (3), wherein the test voltage is selected such that said voltage can be differentiated from the intermediate circuit voltage and the ground potential able to be applied to the feed connections by the motor controller (4), particularly wherein the test voltage corresponds to half the intermediate circuit voltage *v_{DC_Link}* of the motor controller (4) plus the simulated induced counter-voltages in the corresponding motor phase.

7. The method according to claim 6, **characterized in that** the test voltage is applied to the feed connections (3) over a latency time *t₃*, and that the actuated state *S_{PH}(j)=0* of a feed connection *j* is detected when the magnitude of the differential voltage *v_{diff}(j)* between the output voltage *vᵢₙᵥ(j)* measured at the feed connection *j* of the motor controller (4) and the test voltage applied across the load connections (2) after the latency time *t₃* is greater than a predetermined voltage threshold *v_{TH}.*

8. The method according to claim 7, **characterized in that** the latency time *t₃* is set at least as long as is necessary for the emulator power electronics (5) to reliably set the specification for the test voltage.

9. The method according to claim 7 or 8, **characterized in that** after the actuated state *S_{PH}(j)=0* of the feed connection *j* of the motor controller (4) is detected, the emulator controller (6) actuates the emulator power electronics (5) such that the phase current *iₑₘᵤₗₐₜₑ(j)* calculated by the emulator controller (6) flows through the feed connection *j* now actuated by the motor controller (4), particularly wherein the model of a block commutated motor is used as the motor model (8) when two simultaneously actuated feed connections (3) are detected, and wherein the model of a sine commutated motor is used as the motor model (8) when three simultaneously actuated feed connections (3) are detected.

10. The method according to any one of the claims 1 through 9, **characterized in that** the transition of a feed connection *k* of the motor controller (4) from the actuated state *S_{PH}(k)*=*0* to the non-actuated state *S_{PH}(k)*=*1* is detected by the emulator controller (6) **in that** the time integral *V_{Integral,1}* is calculated for the corresponding measured output voltage *vᵢₙᵥ(k)* of the feed connection *k* of the motor controller (4) over a time interval *TI_{Vcalc,1}* in which the phase current *iₑₘᵤₗₐₜₑ (k)* calculated by the emulator controller (6) drops from a specified first current value *i_{emulate,1}(k)* to a specified second current value *i_{emulate,2}(k)*, and the time integral *V_{Integral,1}* is greater than a specified voltage time threshold *V_{DiodeTH,1}(k).*

11. The method according to claim 10, **characterized in that** the specified first current value *i_{emulate,1}(k)* is less than half of the maximum calculated current value of the phase current *i_{emulate,}(k),* particularly less than one-fourth of the maximum calculated current value of the phase current *i_{emulate,}(k),* and/or that the specified second current value *i_{emulate,2}(k)* is a fraction of the specified first current value *i_{emulate,1}(k),* preferably three-fourths of the specified first current value, *i_{emulate,1}(k),* and/or that the specified voltage time threshold *V_{DiodeTH,1}(k)* is the time integral *V_{Integral,1}* of half of the recovery diode voltage of a recovery diode (18) comprised by the motor controller (4).

12. The method according to claim 10 or 11, **characterized in that** the transition of all feed connections of the motor controller (4) from the actuated state *S_{PH}(k)*=*0* to the non-actuated state *S_{PH}(k)=1* is examined by the emulator controller (6), and when the transition of two or more feed connections (3) of the motor controller (4) from the actuated state *S_{PH}(k)=0* to the non-actuated state *S_{PH}(k)=1* is detected, the emulator power electronics (5) are disconnected with high impedance from the load connections (2) by means of the switching means (15).

13. A load emulator (1) for simulating a three-phase electric motor, the load connections (2) of the load emulator (1) being connectable in three phases to the feed connections (3) of a motor controller (4) and the load emulator (1) comprising emulator power electronics (5) and an emulator controller (6) for controlling the emulator power electronics (5), the emulator controller (6) determining the feed connections (3) controlled by the motor controller (4) and the non-controlled feed connections (3), and the emulator power electronics (5) being actuated by the emulator controller (6) such that phase currents *iₑₘᵤₗₐₜₑ* calculated by the emulator controller (6) on the basis of a motor model (8) flow in the feed connections (3) actuated by the motor controller (4), and that a phase voltage *Vₑₘᵤₗₐₜₑ* calculated by the emulator controller on the basis of a motor model (8) is applied to the feed connection (3) not actuated by the motor controller (4),
**characterized in that**
the load emulator (1) comprises a switching means (15) by means of which the emulator power electronics (5) can be disconnected with high impedance from the feed connections (3) and by means of which the emulator power electronics (5) can be connected with low impedance to the feed connections (3), so that it is possible to effectively electrically disconnect the emulator power electronics (5) from the motor controller (4), whereby an interaction between the motor controller (4) and the emulator power electronics (5) is prevented, and wherein the feed connections (3) are connected to each other by means of a high-impedance resistor network (16).

14. The load emulator (1) according to claim 13, **characterized in that** for simulating selected operating states of the electric motor, the emulator controller (6) actuates the emulator power electronics (5) and the switching means (15) such that the emulator power electronics (5) are disconnected with high impedance from the feed connections (3) by means of the switching means (15), or the emulator power electronics (5) already disconnected at high impedance from the feed connections (3) are connected to the feed connections (3) at low impedance by means of the switching means (15).

15. The load emulator (1) according to claim 13 or 14, **characterized in that** the high-impedance resistor network (16) is a star connection of three substantially ohmic resistors, wherein each of the free ends of the star connection is connected to a different feed connection (3) of the motor controller (4).

16. The load emulator (1) according to any one of the claims 13 through 15, **characterized in that** the emulator controller (6) is implemented for performing the method according to the characterizing portion of at least one of the claims 3 through 12 when used appropriately.

## Revendications

1. Procédé pour simuler un moteur électrique triphasé avec un émulateur de charge (1), dans lequel l'émulateur de charge (1) est raccordé en trois phases via ses raccords de charge (2) aux raccords d'alimentation (3) d'une unité (4) de commande de moteur et l'émulateur de charge (1) comporte une unité électronique (5) de puissance d'émulateur et une commande (6) d'émulateur pour la commande de l'unité électronique (5) de puissance d'émulateur, dans lequel la commande (6) d'émulateur détermine les raccords d'alimentation (3) pilotés par la commande (4) de moteur et les raccords d'alimentation (3) non pilotés, et l'unité électronique (5) de puissance d'émulateur est pilotée par la commande (6) d'émulateur de sorte que des courants de phase *iₑₘᵤₗₐₜₑ* calculés par la commande (6) d'émulateur sur la base d'un modèle (8) de moteur circulent dans les raccords d'alimentation (3) pilotés par la commande (4) de moteur et qu'une tension de phase *Vₑₘᵤₗₐₜₑ* calculée par la commande d'émulateur sur la base d'une modèle (8) de moteur soit appliquée sur le raccord (3) d'alimentation non piloté par la commande (4) de moteur,
**caractérisé en ce que**
l'émulateur de charge (1) comprend un moyen de commutation (15) avec lequel l'unité électronique (5) de puissance d'émulateur peut être déconnectée à haute impédance des raccords d'alimentation (3) et avec lequel l'unité électronique (5) de puissance d'émulateur peut être connectée à basse impédance aux raccords d'alimentation (3), de sorte qu'il est possible d'isoler électriquement, efficacement, l'unité électronique (5) de puissance d'émulateur de l'unité (4) de commande de moteur, ce par quoi une interaction entre l'unité (4) de commande de moteur et l'unité électronique (5) de puissance d'émulateur est empêchée, et dans lequel les raccords d'alimentation (3) sont reliées les uns aux autres via un réseau de résistance (16) à haute impédance,
**en ce que**, pour simuler des états de fonctionnement sélectionnés du moteur électrique, l'unité électronique (5) de puissance d'émulateur est déconnectée à haute impédance des raccords d'alimentation (3) à l'aide du moyen de commutation (15) ou l'unité électronique (5) de puissance d'émulateur, qui est déjà déconnectée à haute impédance des raccords d'alimentation (3), est connectée à basse impédance aux raccords d'alimentation (3) à l'aide du moyen de commutation (15).

2. Procédé selon la revendication 1, **caractérisé en ce qu'**un couplage en étoile de trois résistances essentiellement ohmiques est choisi en tant que réseau de résistance (16) à haute impédance, chacune des extrémités libres du couplage en étoile étant connectée à un raccord d'alimentation (3) à chaque fois différent de l'unité (4) de commande de moteur.

3. Procédé selon la revendication 1 ou 2, **caractérisé en ce que**, comme état initial, l'unité (4) de commande de moteur ne commande aucun raccord d'alimentation (3) et l'unité électronique (5) de puissance d'émulateur est isolée à haute impédance des raccords d'alimentation (3) via le moyen de commutation (15), **en ce qu'**un démarrage du moteur par moteur est détecté par l'unité (4) de commande de moteur par le commencement d'une commander des raccords d'alimentation (3) lorsqu'au moins l'une des tensions différentielles initiales *v_{inv,diff} (i,j)* déterminées par mesure entre les raccords d'alimentation *(3, i, j)* de l'unité (4) de commande de moteur est supérieure à une valeur seuil de tension *THimpedance.* prédéterminée.

4. Procédé selon l'une quelconque des revendications 1 à 3, **caractérisé en ce que**, comme état initial, l'unité (4) de commande de moteur ne commande aucun raccord d'alimentation (3) et l'unité électronique (5) de puissance d'émulateur est isolée à haute impédance des raccords d'alimentation (3) via le moyen de commutation (15), **en ce qu'**un démarrage du moteur par générateur est détecté lorsque la vitesse de rotation du moteur *ω_{mot,emu}* du modèle (8) de moteur est évaluée et la vitesse de rotation du moteur *ω_{mot,emu}* n'est pas égale à zéro.

5. Procédé selon la revendication 3 ou 4, **caractérisé en ce que**, en cas de détection du démarrage de moteur par moteur ou par générateur, l'unité électronique (5) de puissance d'émulateur est connectée à basse impédance par le moyen de commutation (15) aux raccords d'alimentation (3), et la commande (6) d'émulateur commande les raccords de charge (2) de l'unité électronique (5) de puissance d'émulateur de sorte qu'une tension soit appliquée aux raccords de charge (2).

6. Procédé selon la revendication 5, **caractérisé en ce que** la commande (6) d'émulateur commande les raccords de charge (2) de l'unité électronique (5) de puissance d'émulateur de sorte qu'une tension d'essai est appliquée aux raccords d'alimentation (3), dans lequel la tension d'essai est choisie de sorte que celle-ci puisse être distinguée de la tension de circuit intermédiaire et du potentiel de masse, qui peuvent être appliqués aux raccords d'alimentation par la commande (4) de moteur, dans lequel, en particulier, la tension d'essai correspond à la moitié de la tension de circuit intermédiaire *v_{DC_Link}* de la commande (4) de moteur plus les tensions inverses induites simulées dans la phase de moteur correspondante.

7. Procédé selon la revendication 6, **caractérisé en ce que** l'application de la tension d'essai aux raccords d'alimentation (3) a lieu pendant un temps de latence t₃, **en ce que** l'état piloté *S_{PH}(j)=0* d'un raccord d'alimentation j est détecté si la valeur absolue de la tension différentielle *v_{diff}(j)* entre la tension de sortie *vᵢₙᵥ(j)* mesurée au raccord d'alimentation *j* de la commande (4) de moteur et la tension d'essai appliquée via les raccords de charge (2) est supérieure à une valeur seuil de tension prédéterminée *v_{TH}* après le temps de latence t₃.

8. Procédé selon la revendication 7, **caractérisé en ce que** le temps de latence *t₃* est dimensionné au moins aussi long que l'unité électronique (5) de puissance d'émulateur a besoin pour régler fiablement la valeur de consigne de la tension d'essai.

9. Procédé selon la revendication 7 ou 8, **caractérisé en ce que**, après la détection de l'état piloté *S_{PH}(j)=0* du raccord d'alimentation *j* de la commande (4) de moteur, la commande (6) d'émulateur commande l'unité électronique (5) de puissance d'émulateur de manière à ce que le courant de phase *iₑₘᵤₗₐₜₑ(j)* calculé par la commande (6) d'émulateur circule à travers le raccord d'alimentation *j* à présent piloté par la commande (4) de moteur, en particulier dans lequel, à la détection de deux raccords d'alimentation (3) pilotés simultanément, le modèle d'un moteur à commutation en blocs est utilisé en tant que modèle (8) de moteur et dans lequel, à la détection de trois raccords d'alimentation (3) pilotés simultanément, le modèle d'un moteur à commutation sinusoïdale est utilisé en tant que modèle (8) de moteur.

10. Procédé selon l'une quelconque des revendications 1 à 9, **caractérisé en ce que** la commande (6) d'émulateur détecte la transition d'un raccord d'alimentation *k* de la commande (4) de moteur de l'état piloté *S_{PH}(k)*=*0* à l'état non piloté *S_{PH}(k)=1* en ce sens que, dans un intervalle de temps *TI_{Vcalc,1}* dans lequel le courant de phase *iₑₘᵤₗₐₜₑ(k)* calculé par la commande (6) d'émulateur chute d'une première valeur de courant prédéterminée *i*_{*e*-}*_{mulate,1}(k)* à une deuxième valeur de courant prédéterminée *i_{emu-late,2}(k),* l'intégrale de temps *V_{Integral,1}* est calculée sur la tension de sortie mesurée correspondante *vᵢₙᵥ(k)* du raccord d'alimentation *k* de la commande (4) de moteur, et l'intégrale de temps *V_{Integral,1}* est supérieure à une valeur seuil de tension-temps prédéterminée *V_{DiodeTH,1}(k).*

11. Procédé selon la revendication 10, **caractérisé en ce que** la première valeur de courant prédéterminée *i_{emulate,1}(k)* est inférieure à la moitié de la valeur de courant maximale calculée du courant de phase *i_{emulate,}(k),* en particulier inférieure à un quart de la valeur de courant maximale calculée du courant de phase *i_{emulate,}(k)* et/ou **en ce que** la deuxième valeur de courant prédéterminée *i_{emulate,2}(k)* est une fraction de la première valeur de courant prédéterminée *i_{emulate,1}(k),* est de préférence égale à trois quarts de la première valeur de courant prédéterminée *i*_{*e*-}*_{mulate,1}(k)* et/ou **en ce que** la valeur seuil de tension-temps prédéterminée *V_{DiodeTH,1}(k)* est l'intégrale de temps *V_{Integral,1}* de la moitié de la tension de diode de roue libre d'une diode (18) de roue libre comprise dans la commande (4) de moteur.

12. Procédé selon la revendication 10 ou 11, **caractérisé en ce que** la commande (6) d'émulateur examine la transition de tous les raccords d'alimentation de la commande de moteur (4) de l'état piloté *S_{PH}(k)*=*0* à l'état non piloté *S_{PH}(k)=1* et, à la détection de la transition d'au moins deux raccords d'alimentation (3) de la commande (4) de moteur de l'état piloté *S_{PH}(k)*=*0* à l'état non piloté *S_{PH}(k)=1,* l'unité électronique (5) de puissance d'émulateur est déconnectée à haute impédance des raccords de charge (2) par le moyen de commutation (15).

13. Émulateur de charge (1) pour simuler un moteur électrique triphasé, dans lequel l'émulateur de charge (1) peut être raccordé en trois phases via ses raccords de charge (2) aux raccords d'alimentation (3) d'une unité (4) de commande de moteur et l'émulateur de charge (1) comporte une unité électronique (5) de puissance d'émulateur et une commande (6) d'émulateur pour la commande de l'unité électronique (5) de puissance d'émulateur, dans lequel la commande (6) d'émulateur détermine les raccords d'alimentation (3) pilotés par la commande (4) de moteur et les raccords d'alimentation (3) non pilotés, et l'unité électronique (5) de puissance d'émulateur est pilotée par la commande (6) d'émulateur de sorte que des courants de phase *iₑₘᵤₗₐₜₑ* calculés par la commande (6) d'émulateur sur la base d'un modèle (8) de moteur circulent dans les raccords d'alimentation (3) pilotés par la commande (4) de moteur et qu'une tension de phase *Vₑₘᵤₗₐₜₑ* calculée par la commande d'émulateur sur la base d'une modèle (8) de moteur soit appliquée sur le raccord (3) d'alimentation non piloté par la commande (4) de moteur,
**caractérisé en ce que**
l'émulateur de charge (1) comprend un moyen de commutation (15) avec lequel l'unité électronique (5) de puissance d'émulateur peut être déconnectée à haute impédance des raccords d'alimentation (3) et avec lequel l'unité électronique (5) de puissance d'émulateur peut être connectée à basse impédance aux raccords d'alimentation (3), de sorte qu'il est possible d'isoler électriquement, efficacement, l'unité électronique (5) de puissance d'émulateur de l'unité (4) de commande de moteur, ce par quoi une interaction entre l'unité (4) de commande de moteur et l'unité électronique (5) de puissance d'émulateur est empêchée, et dans lequel les raccords d'alimentation (3) sont reliées les uns aux autres via un réseau de résistance (16) à haute impédance.

14. Émulateur de charge (1) selon la revendication 13, **caractérisé en ce que** la commande (6) d'émulateur, pour simuler des états de fonctionnement sélectionnés du moteur électrique, pilote l'unité électronique (5) de puissance d'émulateur et le moyen de commutation (15) de sorte que l'unité électronique (5) de puissance d'émulateur soit déconnectée à haute impédance des raccords d'alimentation (3) à l'aide du moyen de commutation (15) ou que l'unité électronique (5) de puissance d'émulateur, qui est déjà déconnectée à haute impédance des raccords d'alimentation (3), soit connectée à basse impédance aux raccords d'alimentation (3) à l'aide du moyen de commutation (15).

15. Émulateur de charge (1) selon la revendication 13 ou 14, **caractérisé en ce que** le réseau de résistance (16) à haute impédance est un couplage en étoile de trois résistances essentiellement ohmiques, dans lequel chacune des extrémités libres du couplage en étoile est connectée à un raccord d'alimentation (3) différent de l'unité (4) de commande de moteur.

16. Émulateur de charge (1) selon l'une quelconque des revendications 13 à 15, **caractérisé en ce que** la commande (6) d'émulateur est conçue de manière à exécuter, lorsqu'il est utilisé conformément à sa destination, le procédé selon la partie de caractérisation d'au moins une revendication des revendications 3 à 12.
